(19) **Europäisches Patentamt European Patent Office Office européen des brevets**

(11) **EP 3 182 590 B1**

(12) **FASCICULE DE BREVET EUROPEEN**

(45) Date de publication et mention de la délivrance du brevet:
**23.10.2019 Bulletin 2019/43**

(51) Int Cl.:
*H03K 19/185* (2006.01)  *H03K 19/20* (2006.01)
*H03K 19/02* (2006.01)  *H03K 19/00* (2006.01)

(21) Numéro de dépôt: **16204534.8**

(22) Date de dépôt: **15.12.2016**

(54) **CELLULE LOGIQUE À FAIBLE CONSOMMATION**

LOGIKZELLE MIT GERINGEM VERBRAUCH

LOW-POWER LOGIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2015 FR 1562812**

(43) Date de publication de la demande:
**21.06.2017 Bulletin 2017/25**

(73) Titulaire: **COMMISSARIAT À L'ÉNERGIE ATOMIQUE ET AUX ÉNERGIES ALTERNATIVES 75015 Paris (FR)**

(72) Inventeurs:
• **FANET, Hervé 38420 REVEL (FR)**
• **HOURI, Samer 2628 CJ DELFT (NL)**
• **PILLONNET, Gaël 38360 SASSENAGE (FR)**

(74) Mandataire: **Cabinet Beaumont 4, Place Robert Schuman B.P. 1529 38025 Grenoble Cedex 1 (FR)**

(56) Documents cités:
**EP-A1- 2 549 654        EP-A2- 0 986 077 US-A1- 2011 002 168**

## Description

### Domaine

La présente demande concerne le domaine des circuits intégrés comportant des cellules mettant en oeuvre des fonctions logiques, aussi appelées cellules logiques ou portes logiques. La présente demande vise plus particulièrement des cellules logiques à faible consommation, et un circuit intégré comportant de telles cellules logiques.

### Exposé de l'art antérieur

Les circuits logiques de l'état de la technique sont généralement réalisés à base de transistors à effet de champ, par exemple en technologie CMOS (de l'anglais "Complementary Metal-Oxide Semiconductor") qui associe deux transistors MOS complémentaires, l'un de type N, l'autre de type P, sur un même support.

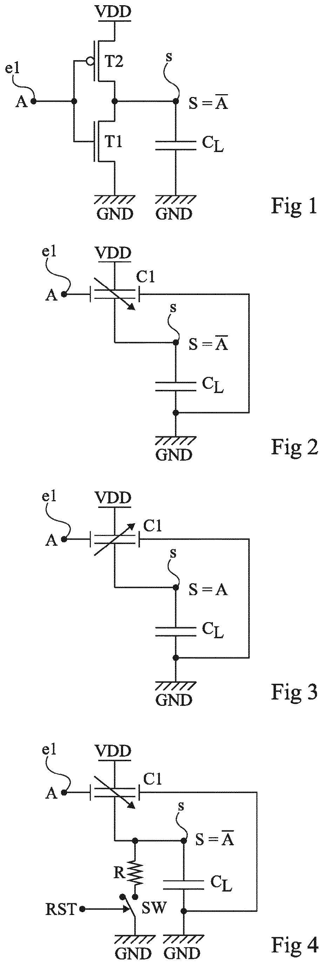

La figure 1 est un schéma électrique d'un exemple d'une cellule logique inverseuse, c'est-à-dire réalisant la fonction de base NON, en technologie CMOS. Cette cellule comprend une association en série d'un transistor MOS à canal N T1 et d'un transistor MOS à canal P T2 entre un noeud GND d'application d'un potentiel de référence du circuit (par exemple la masse) et un noeud VDD d'application d'une tension d'alimentation continue référencée par rapport au noeud GND. Plus particulièrement, le transistor T1 a sa source connectée au noeud GND et son drain connecté au drain du transistor T2, et le transistor T2 a sa source connectée au noeud VDD. Les grilles des transistors T1 et T2 sont connectées à un même noeud e1 d'application d'un signal logique d'entrée A. Les drains des transistors T1 et T2 sont connectés à un même noeud s de fourniture d'un signal logique de sortie S. Par souci de simplification, la tension d'alimentation de la cellule est désignée par la même référence VDD que le noeud sur laquelle elle est appliquée. Dans cet exemple, les signaux d'entrée A et de sortie S sont des tensions référencées par rapport au noeud GND. Sur la figure 1, un condensateur $C_L$ connecté entre le noeud de sortie s et le noeud de référence GND a été représenté, schématisant la capacité de sortie de la cellule. En pratique, la capacité de sortie $C_L$ ne correspond pas à un composant spécifiquement réalisé et connecté au noeud de sortie s de la cellule, mais représente la somme des capacités parasites des différents éléments connectés au noeud s, notamment des pistes d'interconnexion, les transistors T1 et T2, ou encore une autre cellule logique (non représentée) dont l'entrée est connectée au noeud s.

Le fonctionnement de l'inverseur de la figure 1 est le suivant. Lorsque le signal d'entrée A est à un état haut, par exemple à une valeur proche de la tension d'alimentation VDD, le transistor T2 est bloqué et le transistor T1 est passant. Il en résulte que le signal S est maintenu à un état bas, proche de 0 V. Lorsque le signal d'entrée A est à un état bas, par exemple à une valeur proche de 0 V, le transistor T1 est bloqué et le transistor T2 est passant. Il en résulte que le signal S est maintenu à un état haut, proche de VDD. La cellule de la figure 1 réalise donc bien une fonction d'inverseur, c'est-à-dire que le signal logique de sortie S est égal au complément $\overline{A}$ du signal logique d'entrée A.

L'inverseur de la figure 1 se comporte comme un pont diviseur de tension résistif à résistances commandables, les résistances commandables étant constituées par les transistors T1 et T2. En effet, si l'on appelle $R_{T1}$ la résistance du transistor T1 et $R_{T2}$ la résistance du transistor T2, la valeur de la tension de sortie de la cellule s'exprime comme suit :

$$S = VDD \frac{R_{T1}}{R_{T1}+R_{T2}}$$

Lorsque les transistors T1 et T2 sont respectivement à l'état bloqué et à l'état passant, la résistance $R_{T1}$ est relativement grande et la résistance $R_{T2}$ est relativement petite. Le terme $R_{T1}/(R_{T1}+R_{T2})$ est alors proche de 1, et le signal S est proche de VDD. Lorsque les transistors T1 et T2 sont respectivement à l'état passant et à l'état bloqué, la résistance $R_{T1}$ est relativement petite et la résistance $R_{T2}$ est relativement grande. Le terme $R_{T1}/(R_{T1}+R_{T2})$ est alors proche de 0, et le signal S est proche de 0 V.

Plus généralement, toutes les fonctions logiques de base usuellement utilisées dans les circuits intégrés peuvent être réalisées par des cellules présentant des architectures du même type que celle de la figure 1, c'est-à-dire comportant des transistors montés en ponts diviseurs de tension résistifs.

Les cellules logiques à base de transistors montés en ponts résistifs présentent toutefois des limitations en termes de consommation électrique. En particulier, on peut démontrer qu'une cellule du type décrit en relation avec la figure 1 dissipe, à chaque changement d'état de son signal d'entrée, une quantité d'énergie E donnée par la relation :

$$E=0,5*C_L*VDD^2$$

Pour réduire la consommation dynamique des cellules, on peut chercher à réduire la tension d'alimentation VDD des cellules. Toutefois, en pratique, la réduction de la tension d'alimentation s'accompagne d'une augmentation des courants de fuite dans les transistors, et donc de la consommation statique des cellules.

Un autre type de cellules logiques, dites adiabatiques, a été proposé pour réduire la consommation dynamique des cellules. En logique adiabatique, plutôt que de charger et décharger brusquement les capacités de sortie $C_L$ des cellules à chaque changement d'état, comme cela est fait en logique classique, on cherche à réaliser les charges et décharges des capacités $C_L$ de façon progressive. Pour cela, la tension d'alimentation continue VDD utilisée en logique classique est remplacée par une tension d'alimentation variable périodique. La logique adiabatique est une logique dynamique, c'est-à-dire que les états de sortie des cellules logiques ne sont disponibles que pendant une fraction de la période du signal d'horloge formé par la tension d'alimentation. Si l'on désigne par T la durée de charge ou de décharge de la capacité $C_L$, par $R_T$ la résistance du transistor T1 ou T2 utilisé pour charger ou décharger la capacité $C_L$, et si on considère une tension d'alimentation alternative périodique variant de 0 V à VDD, on peut montrer, en première approximation, que la quantité d'énergie E dissipée lors d'un changement d'état d'une cellule s'exprime par la relation :

$$E = C_L * VDD^2 * \frac{2 R_T C_L}{T}$$

Ainsi, si la durée T de charge et de décharge des capacités $C_L$ des cellules est choisie suffisamment élevée devant la constante de temps $R_T C_L$ des cellules, l'énergie dissipée à chaque changement d'état peut être réduite de façon significative par rapport à des circuits logiques classiques du type décrit en relation avec la figure 1.

Les principes de fonctionnement de la logique adiabatique sont décrits dans diverses publications, et notamment dans l'article intitulé "Low power Digital systems based on adiabatic switching principles", de W C Athas, IEEE transactions on VLSI systems VOL 2, N°4 December 1994.

En pratique, les circuits logiques adiabatiques réalisés en technologie CMOS, présentent eux aussi des limitations en termes de consommation. En particulier, un transistor MOS présentant toujours une tension de seuil non nulle, il subsiste inévitablement une dissipation énergétique non adiabatique résiduelle à chaque commutation des transistors de la cellule. La réduction de la tension de seuil des transistors dans les technologies CMOS avancées permet de réduire cette dissipation dynamique non adiabatique, mais s'accompagne généralement d'une augmentation des courants de fuite, et donc de la consommation statique des cellules.

Les demandes de brevet français FR2978311 du 22 juillet 2011 et FR3009722 du 14 aout 2013, précédemment déposées par le demandeur, ainsi que l'article intitulé "Limits of CMOS Technology and Interest of NEMS Relays for Adiabatic Logic Applications", de S. Houri et al. (IEEE TRANSACTIONS ON CIRCUITS AND SYSTEMS I, DECEMEBER 2014), décrivent des circuits logiques adiabatiques dans lesquels les transistors MOS sont remplacés par des interrupteurs microélectromécaniques ou nanoélectromécaniques. L'utilisation d'interrupteurs électromécaniques permet de diminuer significativement la consommation statique, ces interrupteurs présentant des courants de fuite nuls ou négligeables à l'état bloqué. De plus, les tensions de commande de fermeture et d'ouverture d'un interrupteur microélectromécanique ou nanoélectromécanique étant relativement faibles devant la tension de seuil d'un transistor MOS, la consommation dynamique non adiabatique résiduelle liée aux effets de seuil peut être significativement réduite par rapport à des circuits logiques adiabatiques à base de transistors MOS.

Dans la pratique, l'utilisation d'interrupteurs microélectromécaniques ou nanoélectromécaniques pose toutefois des difficultés. En effet, ces interrupteurs présentent souvent des résistances à l'état passant relativement élevées, liées notamment à la mauvaise qualité du contact électrique entre la partie conductrice fixe et la partie conductrice mobile de l'interrupteur. Ceci entraine une dissipation d'énergie supplémentaire qui annule en partie le gain procuré par la mise en oeuvre d'une logique adiabatique.

La demande de brevet EP0986077 divulgue par ailleurs un dispositif comprenant un condensateur à capacité variable multiport.

Résumé

Ainsi, un mode de réalisation prévoit un circuit logique comportant au moins une première cellule logique et une deuxième cellule logique cascadées en série, chaque cellule logique comportant au moins un premier condensateur à capacité variable ayant des première et deuxième électrodes principales séparées par une région isolante, et des première et deuxième électrodes de commande isolées électriquement des première et deuxième électrodes principales et adaptée à recevoir un signal de commande pour faire varier la capacité entre les première et deuxième électrodes principales, les première et deuxième électrodes de commande étant reliées respectivement à un noeud d'application d'un premier signal logique d'entrée de la cellule et à un noeud de référence de la cellule, et les première et deuxième électrodes principales étant reliées respectivement à un noeud d'application d'une tension d'alimentation de la cellule et à un noeud flottant de fourniture d'un signal logique de sortie de la cellule, dans lequel la première cellule a son noeud flottant de fourniture d'un signal logique de sortie connecté au noeud d'application du premier signal logique d'entrée de la deuxième cellule.

Selon un mode de réalisation, au moins une des première et deuxième cellules logiques comporte en outre un deuxième condensateur à capacité variable ayant des première et deuxième électrodes principales séparées par une région isolante, et des première et deuxième électrodes de commande isolées électriquement des première et deuxième électrodes principales du deuxième condensateur et adaptées à recevoir un signal de commande pour faire varier la capacité entre les première et deuxième électrodes principales du deuxième condensateur, les première et deuxième électrodes de commande du deuxième condensateur étant reliées respectivement à un noeud d'application d'un deuxième signal logique d'entrée de la cellule et au noeud de référence de la cellule, les premier et deuxième condensateurs étant connectés en série, via leurs électrodes principales, entre le noeud d'application de la tension d'alimentation de la cellule et le noeud flottant de fourniture du signal logique de sortie de la cellule, la première électrode principale du premier condensateur étant connectée au noeud d'application de la tension d'alimentation de la cellule, la deuxième électrode principale du premier condensateur étant connectée à la première électrode principale du deuxième condensateur, et la deuxième électrode principale du deuxième condensateur étant connectée au noeud flottant de fourniture du signal logique de sortie de la cellule, de sorte que la deuxième électrode principale du premier condensateur est reliée au noeud flottant de fourniture d'un signal logique de sortie de la cellule par l'intermédiaire du deuxième condensateur.

Selon un mode de réalisation, ladite au moins une des première et deuxième cellules, les premier et deuxième condensateurs sont tous deux des condensateurs à variation positive de capacité ou sont tous deux des condensateurs à variation négative de capacité.

Selon un mode de réalisation, au moins une des première et deuxième cellules logiques comporte en outre un deuxième condensateur à capacité variable ayant des première et deuxième électrodes principales séparées par une région isolante, et des première et deuxième électrodes de commande isolées électriquement des première et deuxième électrodes principales du deuxième condensateur et adaptées à recevoir un signal de commande pour faire varier la capacité entre les première et deuxième électrodes principales du deuxième condensateur, les première et deuxième électrodes de commande du deuxième condensateur étant reliées respectivement à un noeud d'application d'un deuxième signal logique d'entrée de la cellule et au noeud de référence de la cellule, les premier et deuxième condensateurs étant connectés en parallèle, via leurs électrodes principales, entre le noeud d'application de la tension d'alimentation de la cellule et le noeud flottant de fourniture du signal logique de sortie de la cellule, les premières électrodes principales des premier et deuxième condensateurs étant connectées au noeud d'application de la tension d'alimentation de la cellule, et les deuxièmes électrodes principales des premier et deuxième condensateurs étant connectées au noeud flottant de fourniture du signal logique de sortie de la cellule.

Selon un mode de réalisation, ladite au moins une des première et deuxième cellules, les premier et deuxième condensateurs sont tous deux des condensateurs à variation positive de capacité ou sont tous deux des condensateurs à variation négative de capacité.

Selon un mode de réalisation, chaque cellule comporte un interrupteur de réinitialisation reliant le noeud flottant de fourniture du signal logique de sortie de la cellule au noeud de référence de la cellule.

Selon un mode de réalisation, dans chaque cellule, la tension d'alimentation de la cellule est une tension continue.

Selon un mode de réalisation, dans chaque cellule, la tension d'alimentation de la cellule est une tension variable périodique.

Selon un mode de réalisation, chaque cellule comporte en outre un circuit de maintien comportant un condensateur à capacité variable ayant des première et deuxième électrodes principales séparées par une région isolante, et des première et deuxième électrodes de commande isolées électriquement des première et deuxième électrodes principales du condensateur à capacité variable du circuit de maintien et adaptées à recevoir un signal de commande pour faire varier la capacité entre les première et deuxième électrodes principales du condensateur à capacité variable du circuit de maintien, les première et deuxième électrodes de commande du condensateur à capacité variable du circuit de maintien étant reliées respectivement au noeud flottant de fourniture du signal logique de sortie de la cellule et au noeud de référence de la cellule, et les première et deuxième électrodes principales du condensateur à capacité variable du circuit de maintien étant reliées respectivement au noeud d'application de la tension d'alimentation de la cellule et au noeud flottant de fourniture du signal logique de sortie de la cellule.

Selon un mode de réalisation, les cellules ne comportent pas de circuit de maintien spécifique pour maintenir ledit au moins un premier condensateur à capacité variable dans un état lorsque le signal de commande qui lui est appliqué varie, une fonction de maintien étant assurée par un phénomène physique inhérent à la cellule.

Selon un mode de réalisation, dans chaque cellule, la tension d'alimentation de la cellule est de forme trapézoïdale ou sinusoïdale.

Selon un mode de réalisation, dans chaque cellule, ledit au moins un premier condensateur à capacité variable est de type micro ou nanoélectromécanique.

Selon un mode de réalisation, dans chaque cellule, la variation de capacité dudit au moins un premier condensateur à capacité variable est obtenue en faisant varier la surface de ses électrodes principales, ou en faisant varier la distance entre ses électrodes principales, ou en faisant varier la constante diélectrique d'un matériau séparant ses électrodes principales.

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1, précédemment décrite, est un schéma électrique d'un exemple d'une cellule logique ;

la figure 2 est un schéma électrique d'un exemple d'une cellule logique selon un premier mode de réalisation ;

la figure 3 est un schéma électrique d'un autre exemple d'une cellule logique selon le premier mode de réalisation ;

la figure 4 est un schéma électrique d'une variante de réalisation d'une cellule logique selon le premier mode de réalisation ;

la figure 5 est un schéma bloc simplifié d'un circuit comportant plusieurs cellules logiques selon le premier mode de réalisation ;

la figure 6 est un diagramme illustrant le comportement du circuit de la figure 5 ;

la figure 7 est un schéma électrique d'un autre exemple d'une cellule logique selon le premier mode de réalisation ;

la figure 8 est un schéma électrique d'un autre exemple d'une cellule logique selon le premier mode de réalisation ;

la figure 9 est un schéma électrique d'un autre exemple d'une cellule logique selon le premier mode de réalisation ;

la figure 10 est un schéma électrique d'un autre exemple d'une cellule logique selon le premier mode de réalisation ;

la figure 11 est un schéma électrique d'une variante de réalisation d'une cellule logique selon le premier mode de réalisation ;

la figure 12 est un schéma électrique d'un exemple d'une cellule logique selon un deuxième mode de réalisation ;

la figure 13 est un diagramme illustrant le fonctionnement de la cellule de la figure 12 ;

la figure 14 est un schéma électrique d'un autre exemple d'une cellule logique selon le deuxième mode de réalisation ;

la figure 15 est un schéma de principe illustrant, sous forme de blocs, une cellule logique selon le premier ou deuxième mode de réalisation ;

les figures 16A et 16B sont des vues en coupe d'un exemple de réalisation d'un condensateur à capacité variable d'une cellule logique selon le premier ou deuxième mode de réalisation ;

les figures 17A et 17B sont des vues en coupe d'une variante de réalisation d'un condensateur à capacité variable d'une cellule logique selon le premier ou deuxième mode de réalisation ;

la figure 18 est une vue en coupe d'une autre variante de réalisation d'un condensateur à capacité variable d'une cellule logique selon le premier ou deuxième mode de réalisation ; et

la figure 19 est une vue en coupe d'une autre variante de réalisation d'un condensateur à capacité variable d'une cellule logique selon le premier ou deuxième mode de réalisation.

## Description détaillée

De mêmes éléments ont été désignés par de mêmes références aux différentes figures et, de plus, les diverses figures ne sont pas tracées à l'échelle. Sauf précision contraire, les expressions "approximativement", "sensiblement", "environ" et "de l'ordre de" signifient à 20 % près, de préférence à 10 % près. Dans la présente description, on utilise le terme "connecté" pour désigner une liaison électrique directe, sans composant électronique intermédiaire, par exemple au moyen d'une ou plusieurs pistes conductrices, et le terme "couplé" ou le terme "relié", pour désigner une liaison qui peut être directe (signifiant alors "connecté") ou qui peut être réalisée par l'intermédiaire d'un ou plusieurs composants. Dans les exemples décrits, les signaux logiques d'entrée et de sortie d'une cellule logique correspondent à des tensions référencées par rapport à un noeud de référence GND de la cellule, dont le niveau détermine la valeur, haute ou basse, du signal logique. Sauf précision contraire, on entend par signal logique un signal ne pouvant prendre que deux valeurs, une valeur haute, correspondant par exemple à une tension proche de la tension d'alimentation de la cellule, ou une valeur basse, correspondant par exemple à une tension proche de 0 V.

Selon un aspect des modes de réalisation décrits, on prévoit une nouvelle architecture de cellules logiques basée non pas sur des variations de résistances, mais sur des variations de capacité d'un ou plusieurs éléments capacitifs à capacité variable, par exemple des condensateurs à capacité variable. Un avantage est que par principe, un courant ne peut pas circuler de manière permanente dans un ensemble d'un ou plusieurs éléments capacitifs reliés les uns aux autres. La consommation statique d'une telle architecture est donc nulle ou quasiment nulle. On considère ici plus particulièrement des éléments capacitifs à capacité variable présentant des résistances de fuite nulles ou négligeables, et donc des courants de fuite nuls ou négligeables, par exemple des courants de fuite au moins 100 fois plus faibles que ceux d'un transistor MOS. A titre d'exemple, on considère ici des éléments capacitifs à capacité variable présentant des courants de fuite inférieurs à 1 nA, et de préférence inférieurs à 1 pA. On notera que plus la fréquence de fonctionnement des cellules logiques est élevée, plus les courants de fuite des éléments capacitifs à capacité variable peuvent être élevés, sans que cela n'entraine une dégradation significative de la consommation totale de la cellule. A titre d'exemple, à une fréquence de fonctionnement de l'ordre de 1 GHz, des courants de fuite de l'ordre de 1 nA peuvent être tolérés sans dégrader de façon significative la consommation de la cellule, la consommation dynamique pendant une période de fonctionnement étant négligeable devant la puissance dynamique. Pour une fréquence de fonctionnement de l'ordre de 1 MHz, on choisira de préférence des éléments capacitifs présentant des courants de fuite de l'ordre de 1 pA ou moins.

Selon un premier mode de réalisation, les cellules logiques sont alimentées par une tension continue, et la logique réalisée par les cellules est une logique dite statique, c'est-à-dire que les états des signaux de sortie des cellules sont disponibles à tout moment, et non pas uniquement pendant une fraction d'une période d'un signal d'horloge.

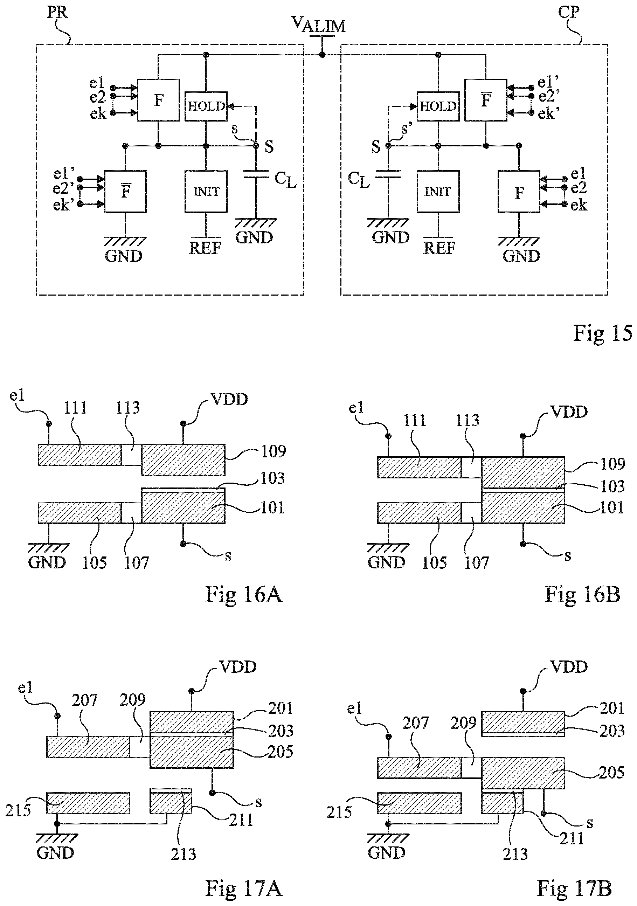

La figure 2 est un schéma électrique d'un exemple d'une cellule logique selon le premier mode de réalisation. La cellule de la figure 2 est une cellule inverseuse. Cette cellule comprend un condensateur C1 à capacité variable ayant deux électrodes principales séparées par une région isolante, par exemple une couche diélectrique, et deux électrodes de commande isolées électriquement des électrodes principales et adaptées à recevoir une tension de commande pour faire varier la capacité entre les électrodes principales. Des exemples de réalisation de tels condensateurs seront décrits plus en détail ci-après en relation avec les figures 16A, 16B, 17A, 17B et 18. Dans l'exemple, le condensateur C1 est un condensateur à variation négative de capacité, c'est-à-dire que la capacité du condensateur C1 prend une valeur basse lorsque la tension appliquée entre ses électrodes de commande est à une valeur haute, et prend une valeur haute lorsque la tension appliquée entre ses électrodes de commande est à une valeur basse. Les deux électrodes principales du condensateur C1 sont respectivement reliées, et de préférence connectées, à un noeud VDD d'application d'une tension d'alimentation continue référencée par rapport à un noeud GND d'application d'un potentiel de référence de la cellule, par exemple la masse, et à un noeud s de fourniture d'un signal logique de sortie S (par exemple référencé par rapport au noeud GND) de la cellule. Les électrodes de commande du condensateur C1 sont respectivement reliées, et de préférence connectées, à un noeud e1 d'application d'un signal logique d'entrée A (référencé par rapport au noeud GND) de la cellule, et au noeud de référence GND. Par souci de simplification, la tension d'alimentation de la cellule est désignée par la même référence VDD que le noeud sur lequel elle est appliquée. Les noeuds e1 et s sont des noeuds flottants, c'est-à-dire non connectés à un noeud d'application d'un potentiel de référence ou d'alimentation de la cellule. Sur la figure 1, un condensateur $C_L$ connecté entre le noeud de sortie s et le noeud de référence GND a été représenté, schématisant la capacité de sortie de la cellule. En pratique, la capacité de sortie $C_L$ peut ne pas comprendre de composant spécifiquement réalisé et connecté au noeud de sortie s, mais correspondre à la somme des capacités des différents éléments connectés au noeud s, notamment des pistes d'interconnexion, ou encore une autre cellule logique capacitive (non représentée) dont l'entrée peut être connectée au noeud s. Un dispositif de commande, non représenté, relié aux électrodes de commande du condensateur C1, est prévu pour appliquer le signal d'entrée A de la cellule.

L'inverseur de la figure 2 se comporte comme un pont diviseur de tension capacitif comportant une capacité commandable correspondant à la capacité du condensateur C1, et une capacité fixe formée par la capacité $C_L$ du noeud de sortie s de la cellule. La tension de sortie de l'inverseur s'exprime comme suit :

$$S = VDD\,\frac{C1}{C1+C_L}$$

En négligeant l'effet des résistances série du circuit (relativement faibles car résultant uniquement des connexions électriques), on peut montrer que cette relation reste vraie à tout instant, y compris pendant les phases de variation de la capacité du condensateur C1. Cette propriété explique non seulement la formation des états logiques en sortie de la cellule, mais aussi que la forme du courant de sortie est liée à la forme du signal d'entrée et à la loi exprimant la variation de capacité du condensateur en fonction de la tension de commande appliquée au condensateur, et non pas à la constante de temps du circuit. Il en résulte que si le signal appliqué en entrée de la cellule varie de manière suffisamment progressive entre les deux niveaux logiques, cette progressivité est conservée en sortie de la cellule. Ainsi, les courants transitoires circulant dans les cellules ne passent pas par des valeurs élevées, ce qui limite la dissipation dans les résistances série résiduelles du circuit. On obtient donc non seulement une consommation statique nulle ou négligeable, mais en outre une consommation dynamique réduite par rapport à des architectures à base de transistors.

Lorsque le signal d'entrée A est à un état haut, la capacité du condensateur C1 prend une valeur basse $C1_{low}$, et le signal de sortie S est à un état bas. Lorsque le signal d'entrée A est à un état bas, la capacité du condensateur C1 prend une valeur haute $C1_{high}$ supérieure à la valeur basse $C1_{low}$, et le signal de sortie S est à un état haut. La cellule de la figure 2 réalise donc bien une fonction d'inverseur ($S=\overline{A}$).

Plus généralement, toutes les fonctions logiques de base usuellement utilisées dans les circuits intégrés peuvent être réalisées par des cellules présentant des architectures du même type que celle de la figure 2, c'est-à-dire basées sur un pont capacitif comportant au moins un condensateur à capacité commandable. Des exemples de cellules adaptées à mettre en oeuvre les fonctions logiques ET, OU, NON ET, NON OU, ainsi que la fonction buffer, seront notamment décrits ci-après. Toutes les fonctions logiques combinatoires et/ou séquentielles habituellement utilisées dans les circuits intégrés peuvent être synthétisées à partir de ces cellules de base. On notera en particulier que toutes les fonctions logiques combinatoires et/ou séquentielles habituellement utilisées dans les circuits intégrés peuvent être synthétisée à partir de cellules NON ET à deux entrées et une sortie, ou à partir du couple de cellules (NON, ET), ou encore à partir du couple de cellules (NON, OU).

La figure 3 est un schéma électrique d'un exemple de réalisation d'une cellule logique de type buffer selon le premier mode de réalisation. La cellule de la figure 3 diffère de la cellule de la figure 2 essentiellement en ce que, dans l'exemple de la figure 3, le condensateur C1 est un condensateur à variation positive de capacité, c'est-à-dire que la capacité du condensateur C1 prend une valeur haute lorsque la tension appliquée entre ses électrodes de commande est à une valeur haute, et prend une valeur basse lorsque la tension appliquée entre ses électrodes de commande est à une valeur basse. Comme dans l'exemple de la figure 2, la tension de sortie de la cellule s'exprime comme suit :

$$ S = VDD \frac{C1}{C1 + C_L} $$

Lorsque le signal d'entrée A est à un état haut, la capacité du condensateur C1 prend une valeur haute $C1_{high}$, et le signal de sortie S est à un état haut. Lorsque le signal d'entrée A est à un état bas, la capacité du condensateur C1 prend une valeur basse $C1_{low}$ inférieure à la valeur haute $C1_{high}$, et le signal de sortie S est à un état bas. La cellule de la figure 2 réalise donc bien une fonction de buffer (S=A). Les avantages en termes de consommation statique et dynamique sont les mêmes que dans la porte à variation négative de capacité de la figure 2.

La figure 4 est un schéma électrique d'une variante de réalisation de la cellule inverseuse de la figure 2. La cellule de la figure 4 comprend les mêmes éléments que la cellule de la figure 2, agencés sensiblement de la même manière. La cellule de la figure 4 diffère de la cellule de la figure 2 en ce qu'elle comprend en outre un circuit de réinitialisation comprenant une résistance R en série avec un interrupteur SW entre le noeud de sortie s et le noeud de référence GND de la cellule (en parallèle de la capacité de sortie $C_L$ de la cellule). La borne de commande de l'interrupteur SW est reliée à un noeud RST d'application d'un signal de commande de réinitialisation de la cellule. La fermeture de l'interrupteur SW permet de réinitialiser le noeud de sortie s de la cellule sensiblement au potentiel du noeud de référence GND de la cellule. A titre de variante, le circuit de réinitialisation peut être adapté à réinitialiser le noeud de sortie s à un potentiel de référence autre que le potentiel du noeud GND. Bien qu'il n'ait pas été représenté sur toutes les figures, un tel circuit de réinitialisation peut être prévu dans toutes les cellules logiques capacitives décrites dans la présente demande, et en particulier dans les cellules des figures 3, 7, 8, 9, 10 et 12.

Pour que des cellules logiques de base puissent être utilisées pour la mise en oeuvre de fonctions complexes dans un circuit intégré, il convient d'une part que les tensions correspondant aux états haut et bas du signal de sortie d'une cellule soient clairement discernables, et d'autre part que les cellules puissent être cascadées en série sans que la discrimination des états haut et bas des signaux de sortie n'en soit affectée. En d'autres termes, les états haut et bas du signal logique de sortie d'une cellule doivent correspondre à des niveaux de tension pouvant être interprétés sans ambiguïté comme étant des états haut et bas du signal logique à l'entrée d'une autre cellule.

Dans une cellule du type décrit en relation avec les figures 2 à 4, le condensateur C1 peut aisément être choisi pour que les valeurs $C1_{low}$ et $C1_{high}$ soient telles que les tensions $VDD*C1_{high}/(C1_{high}+C_L)$ et $VDD*C1_{low}/(C1_{low}+C_L)$ soient clairement discernables.

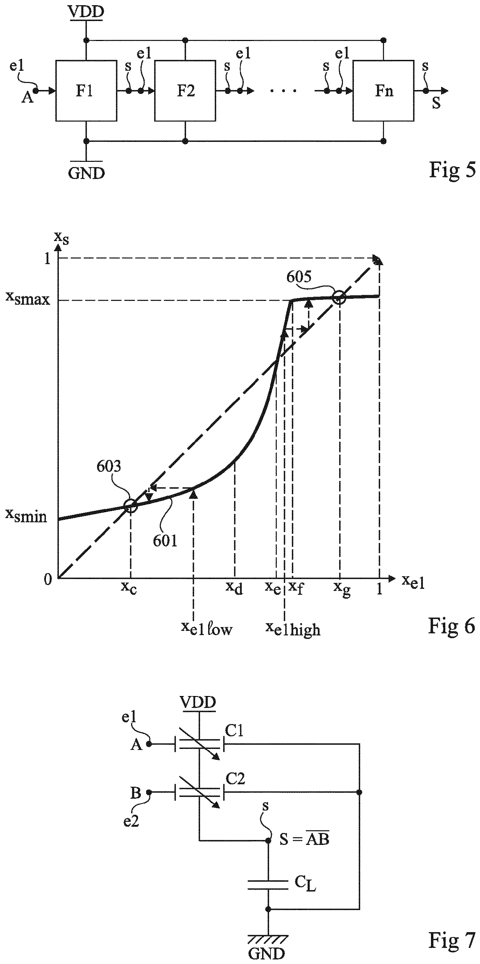

La figure 5 est un schéma bloc simplifié d'un exemple d'un circuit comportant plusieurs cellules logiques selon le premier mode de réalisation, par exemple des cellules buffer du type décrit en relation avec la figure 3, reliées en série. Dans l'exemple représenté, le circuit comprend n cellules logiques F1, F2, ... Fn reliées en série, n étant un entier supérieur à 1. Dans cet exemple, le noeud VDD d'application de la tension d'alimentation est commun à toutes les cellules du circuit, et le noeud GND d'application du potentiel de référence est commun à toutes les cellules du circuit. A l'exception de la cellule F1, chaque cellule Fi, avec i entier allant de 1 à n, a son noeud d'entrée e1 relié au noeud de sortie s de la cellule Fi-1 de rang i-1.

La figure 6 est un diagramme illustrant le comportement du circuit de la figure 5. Plus particulièrement le diagramme de la figure 6 comprend une courbe 601 représentant l'évolution, pour une cellule buffer du type décrit en relation avec la figure 3, de la tension de sortie normalisée $x_s = V_s/VDD$ (en ordonnée) de la cellule en fonction de la tension d'entrée normalisée $x_{e1} = V_{e1}/VDD$ (en abscisse) de la cellule, $V_{e1}$ et $V_s$ désignant respectivement la tension appliquée entre le noeud d'entrée e1 de la cellule et le noeud GND (définissant le signal logique d'entrée A) et la tension fournie entre le noeud de sortie s de la cellule et le noeud GND (définissant le signal logique de sortie S). La diagonale (droite d'équation $x_s = x_e$) a par ailleurs été tracée en traits interrompus sur le diagramme.

Dans l'exemple représenté, la courbe 601 est une courbe monotone croissante. La tension normalisée $x_s$ présente une valeur minimale $x_{smin}$ supérieure à 0 (de l'ordre de 0,19 dans l'exemple représenté) pour $x_{e1}=0$, correspondant à la valeur minimale que peut prendre la capacité du condensateur C1. La tension normalisée $x_s$ présente en outre une valeur maximale $x_{smax}$ inférieure à 1 (de l'ordre de 0,88 dans l'exemple représenté) pour $x_{e1}=1$, correspondant à la valeur maximale que peut prendre la capacité du condensateur C1. Entre les points d'abscisse $x_{e1}=0$ et $x_{e1}=x_d$, avec $x_d$ compris entre 0 et 1, la courbe 601 présente une pente inférieure à 1, c'est-à-dire inférieure à la pente de la diagonale. La courbe 601 coupe la diagonale une première fois en un point d'abscisse $x_{e1}=x_c$, avec $x_c$ compris entre 0 et $x_d$. Entre les points d'abscisse $x_{e1}=x_d$ et $x_{e1}=x_f$, avec $x_f$ comprise entre $x_d$ et 1, la courbe 601 présente une pente supérieure à 1, c'est-à-dire supérieure à la pente de la diagonale. La courbe 601 coupe la diagonale une deuxième fois en un point d'abscisse $x_{e1}=x_e$, avec $x_e$ compris entre $x_d$ et $x_f$. Entre les points d'abscisse $x_{e1}=x_f$ et $x_{e1}=1$, la courbe 601 présente à nouveau une pente inférieure à 1. La courbe 601 coupe la diagonale une troisième fois en un point d'abscisse $x_{e1}=x_g$, avec $x_g$ compris entre $x_f$ et 1. Dans l'exemple représenté, les abscisses $x_c$, $x_d$, $x_e$, $x_f$ et $x_g$ sont respectivement de l'ordre de 0,23, 0,54, 0,67, 0,72 et 0,87. On notera que la courbe de la figure 6 a été tracée pour un condensateur C1 micro ou nanoélectromécanique à variation positive de capacité du type décrit ci-après en relation avec les figures 16A et 16B. Plus généralement, ce type de courbe peut être obtenu quelle que soit la technologie de réalisation du condensateur à capacité variable commandable en tension de la cellule.

Lorsque l'on applique sur l'entrée e1 de la cellule F1 du circuit de la figure 5 une tension $xe1=xe1_{low}$ comprise entre $x_c$ et $x_e$, on constate que la tension de sortie fournie sur le noeud de sortie S de la cellule Fn tend, lorsque n augmente, à converger vers un point stable 603 d'abscisse $x_{e1}=x_c$ de la courbe 601, correspondant au premier point de croisement entre la courbe 601 et la diagonale. Lorsque l'on applique sur l'entrée e1 de la cellule F1 du circuit de la figure 5 une tension $xe1=xe1_{high}$ comprise entre $x_e$ et $x_g$, on constate que la tension de sortie fournie sur le noeud de sortie S de la cellule Fn tend, lorsque n augmente, à converger vers un point stable 605 d'abscisse $x_{e1}=x_g$ de la courbe 601, correspondant au troisième point de croisement entre la courbe 601 et la diagonale.

Ainsi, le diagramme de la figure 6 montre que les cellules logiques capacitives du type décrit ci-dessus peuvent être cascadées en série sans que la discrimination des états haut et bas des signaux logiques n'en soit affectée. A titre d'exemple, les états haut et bas des signaux logiques dans un circuit à base de portes logiques capacitives du type décrit ci-dessus peuvent correspondre respectivement, en valeurs normalisées, aux tensions supérieures à $xe+\Delta$, et aux tensions inférieures à $xe-\Delta$, $\Delta$ étant une marge de sécurité, par exemple comprise dans la plage allant de 0,05 à 0,1.

La figure 7 est un schéma électrique d'un exemple de réalisation d'une cellule logique de type NON ET selon le premier mode de réalisation. La cellule de la figure 7 diffère de la cellule de la figure 2 essentiellement en ce qu'elle comprend non pas un unique, mais deux condensateurs à capacité variable C1 et C2 connectés en série par leurs électrodes principales entre le noeud d'alimentation VDD et le noeud de sortie s de la cellule. Dans l'exemple représenté, le condensateur C1 est connecté au noeud d'alimentation VDD, et le condensateur C2 est connecté au noeud de sortie s de la cellule. Dans cet exemple, les condensateurs C1 et C2 sont tous deux des condensateurs à variation de capacité négative. Les condensateurs C1 et C2 de la cellule de la figure 7 sont par exemple identiques ou similaires au condensateur C1 de la cellule de la figure 2. Les électrodes de commande du condensateur C1 sont reliées, et de préférence connectées, respectivement à un noeud e1 d'application d'un premier signal logique d'entrée A (référencé par rapport au noeud GND) de la cellule et au noeud GND, et les électrodes de commande du condensateur C2 sont reliées, et de préférence connectées, à un noeud e2 d'application d'un deuxième signal logique d'entrée B (référencé par rapport au noeud GND) de la cellule et au noeud GND.

La cellule de la figure 7 se comporte comme un pont diviseur de tension capacitif comportant une capacité commandable correspondant à la capacité équivalente $C_{eq} = 1/(1/C1+1/C2)$ de l'association en série des condensateurs C1 et C2, et une capacité fixe formée par la capacité $C_L$ du noeud de sortie s de la cellule. La tension de sortie de la cellule s'exprime comme suit :

$$S=VDD \frac{C_{eq}}{C_{eq}+C_L} = \frac{VDD}{1+\left(\dfrac{1}{C1}+\dfrac{1}{C2}\right)C_L}$$

Lorsque les signaux d'entrée A et B sont à un état haut, les capacités des condensateurs C1 et C2 prennent des valeurs basses $C1_{low}$ et $C2_{low}$ (par exemple $C1_{low} = C2_{low}$) et le signal de sortie S est à un premier niveau de tension. Lorsque les signaux d'entrée A et B sont à un état bas, les capacités des condensateurs C1 et C2 prennent des valeurs hautes $C1_{high}$ et $C2_{high}$ (par exemple $C1_{high} = C2_{high}$) et le signal de sortie S est à un deuxième niveau de tension supérieur au premier niveau. Lorsque les signaux d'entrée A et B sont à des états distincts, par exemple A=1 et B=0, les capacités des condensateurs C1 et C2 prennent respectivement une valeur basse et une valeur haute, et le signal de sortie S est à un troisième niveau de tension compris entre les premier et deuxième niveaux. En considérant que le premier niveau de tension correspond à un état logique bas du signal S, et que les deuxième et troisième niveaux de tension correspondent à un état logique haut du signal S, la cellule de la figure 7 réalise bien une fonction NON ET ($S=\overline{AB}$).

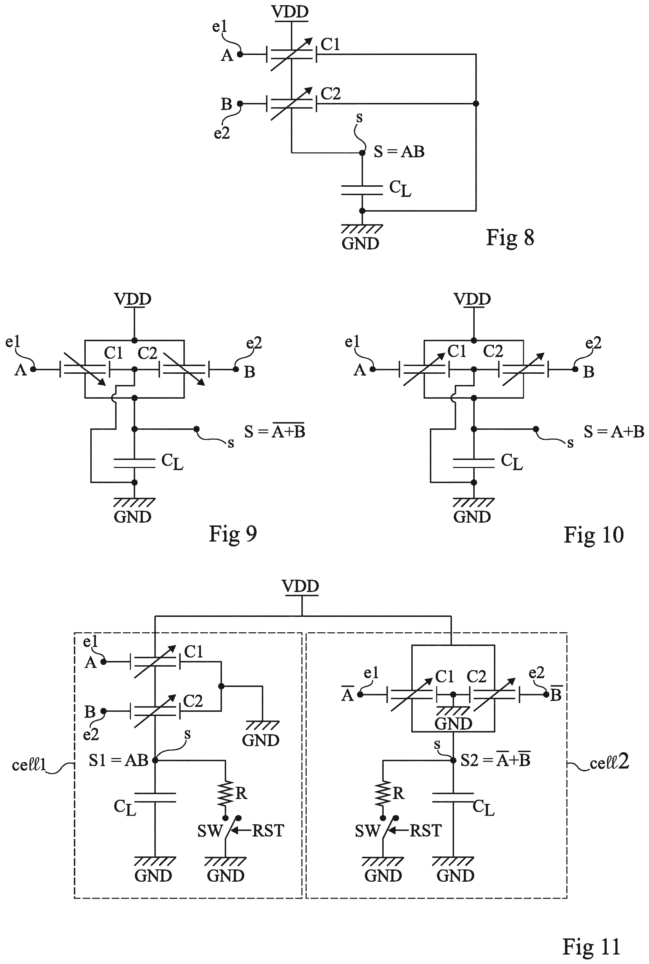

La figure 8 est un schéma électrique d'un exemple de réalisation d'une cellule logique de type ET selon le premier mode de réalisation. La cellule de la figure 8 diffère de la cellule de la figure 7 essentiellement en ce que, dans la cellule de la figure 8, les condensateurs à capacité variable C1 et C2 sont des condensateurs à variation de capacité positive.

Lorsque les signaux d'entrée A et B sont à un état bas, les capacités des condensateurs C1 et C2 prennent des valeurs basses $C1_{low}$ et $C2_{low}$ (par exemple $C1_{low} = C2_{low}$) et le signal de sortie S est à un premier niveau de tension. Lorsque les signaux d'entrée A et B sont à un état haut, les capacités des condensateurs C1 et C2 prennent des valeurs hautes $C1_{high}$ et $C2_{high}$ (par exemple $C1_{high} = C2_{high}$) et le signal de sortie S est à un deuxième niveau de tension supérieur au premier niveau. Lorsque les signaux d'entrée A et B sont à des états distincts, par exemple A=1 et B=0, les capacités des condensateurs C1 et C2 prennent respectivement une valeur basse et une valeur haute, et le signal de sortie S est à un troisième niveau de tension compris entre les premier et deuxième niveaux. En considérant que les premier et troisième niveaux de tension correspondent à un état logique bas du signal S, et que le deuxième niveau de tension correspond à un état logique haut du signal S, la cellule de la figure 8 réalise bien une fonction ET (S=AB).

La figure 9 est un schéma électrique d'un exemple de réalisation d'une cellule logique de type NON OU selon le premier mode de réalisation. La cellule de la figure 9 diffère de la cellule de la figure 7 essentiellement en ce que, dans la cellule de la figure 9, les condensateurs à capacité variable C1 et C2 ne sont pas connectées en série mais en parallèle (par leurs électrodes principales) entre le noeud d'alimentation VDD et le noeud de sortie s de la cellule.

La cellule de la figure 9 se comporte comme un pont diviseur de tension capacitif comportant une capacité commandable correspondant à la capacité équivalente $C_{eq} = C1+C2$ de l'association en parallèle des condensateurs C1 et C2, et une capacité fixe formée par la capacité $C_L$ du noeud de sortie s de la cellule. La tension de sortie de la cellule s'exprime comme suit :

$$S = VDD \frac{C_{eq}}{C_{eq}+C_L} = VDD \frac{C1+C2}{C+C2+C_L}$$

Lorsque les signaux d'entrée A et B sont à un état haut, les capacités des condensateurs C1 et C2 prennent des valeurs basses $C1_{low}$ et $C2_{low}$ (par exemple $C1_{low} = C2_{low}$) et le signal de sortie S est à un premier niveau de tension. Lorsque les signaux d'entrée A et B sont à un état bas, les capacités des condensateurs C1 et C2 prennent des valeurs hautes $C1_{high}$ et $C2_{high}$ (par exemple $C1_{high} = C2_{high}$) et le signal de sortie S est à un deuxième niveau de tension supérieur au premier niveau. Lorsque les signaux d'entrée A et B sont à des états distincts, par exemple A=1 et B=0, les capacités des condensateurs C1 et C2 prennent respectivement une valeur basse et une valeur haute, et le signal de sortie S est à un troisième niveau de tension compris entre les premier et deuxième niveaux. En considérant que les premier et troisième niveaux de tension correspondent à un état logique bas du signal S, et que le deuxième niveau de tension correspond à un état logique haut du signal S, la cellule de la figure 9 réalise bien une fonction NON OU (S=$\overline{A+B}$).

La figure 10 est un schéma électrique d'un exemple de réalisation d'une cellule logique de type OU selon le premier mode de réalisation. La cellule de la figure 10 diffère de la cellule de la figure 9 essentiellement en ce que, dans la cellule de la figure 10, les condensateurs à capacité variable C1 et C2 sont des condensateurs à variation positive de capacité.

Lorsque les signaux d'entrée A et B sont à un état bas, les capacités des condensateurs C1 et C2 prennent des valeurs basses $C1_{low}$ et $C2_{low}$ (par exemple $C1_{low} = C2_{low}$) et le signal de sortie S est à un premier niveau de tension. Lorsque les signaux d'entrée A et B sont à un état haut, les capacités des condensateurs C1 et C2 prennent des valeurs hautes $C1_{high}$ et $C2_{high}$ (par exemple $C1_{high} = C2_{high}$) et le signal de sortie S est à un deuxième niveau de tension supérieur au premier niveau. Lorsque les signaux d'entrée A et B sont à des états distincts, par exemple A=1 et B=0, les capacités des condensateurs C1 et C2 prennent respectivement une valeur basse et une valeur haute, et le signal de sortie S est à un troisième niveau de tension compris entre les premier et deuxième niveaux. En considérant que les deuxième et troisième niveaux de tension correspondent à un état logique haut du signal S, et que le premier niveau de tension correspond à un état logique bas du signal S, la cellule de la figure 10 réalise bien une fonction OU (S=A+B).

Dans les exemples décrits en relation avec les figures 7 à 10, on a décrit uniquement des cellules réalisant des fonctions logiques à deux entrées et une sortie. Les exemples décrits peuvent toutefois être adaptés pour mettre en oeuvre des fonctions logiques à plus de deux entrées, par exemple une fonction ET, OU, NON ET, ou NON OU à trois entrées ou plus, en augmentant le nombre de condensateurs à capacité variable connectés en série ou en parallèle (par leurs électrodes principales) dans la cellule. De plus, selon l'application envisagée, le noeud de sortie s d'une cellule logique capacitive peut être connecté en entrée de plusieurs autres cellules logiques distinctes. Ceci peut conduire à augmenter la capacité de sortie $C_L$ de la cellule. Les valeurs hautes et basses des condensateurs à capacité variable C1 et/ou C2 de la cellule peuvent être choisies pour tenir compte de cette augmentation de la capacité $C_L$.

On notera que dans les exemples décrits ci-dessus, selon le type de fonction logique à réaliser, on utilise soit des condensateurs à variation positive de capacité, soit des condensateurs à variation négative de capacité. Par exemple, la fonction ET est réalisée par des condensateurs à variation positive de capacité, et la fonction NON ET est réalisée par des condensateurs à variation négative de capacité.

A titre de variante, si l'on dispose en entrée du circuit logique non seulement des signaux logiques A et B, mais aussi de leurs compléments $\overline{A}$ et $\overline{B}$, comme cela est le cas dans de nombreuses architectures, toutes les fonctions logiques de base peuvent être réalisées au moyen d'un même type de condensateur à capacité variable, par exemple en utilisant uniquement des condensateurs à variation positive de capacité, ou uniquement des condensateurs à variation négative de capacité. Un avantage est que ceci permet de simplifier la réalisation technologique des circuits logiques.

La figure 11 est un schéma électrique d'un exemple de réalisation d'un circuit logique réalisant les fonctions ET et NON ET en utilisant uniquement des condensateurs à variation positive de capacité. Le circuit de la figure 11 comprend une cellule logique cell1 identique ou similaire à la cellule de la figure 8, recevant sur ses noeuds d'entrée e1 et e2 les signaux logiques A et B. Le circuit de la figure 11 comprend en outre une cellule logique cell2 identique ou similaire à la cellule de la figure 10, recevant sur ses noeuds d'entrée e1 et e2 les signaux logiques $\overline{A}$ et $\overline{B}$. La cellule cell1 fournit sur son noeud de sortie s un signal logique $S1=AB$, et la cellule cell2 fournit sur son noeud de sortie s un signal logique $S2=\overline{A}+\overline{B}=\overline{AB}$. Dans l'exemple représenté, chacune des cellules cell1 et cell2 est munie d'un circuit de réinitialisation du type décrit en relation avec la figure 4.

Selon un deuxième mode de réalisation appelé dynamique, les cellules logiques sont alimentées par une tension variable, et la logique réalisée par les cellules est une logique dite dynamique, c'est-à-dire que les états des signaux logiques ne sont disponibles que pendant une partie de la période d'un signal d'horloge périodique. De même que dans le premier mode de réalisation, les cellules logiques de base selon le deuxième mode de réalisation peuvent être utilisées pour synthétiser toutes les fonctions logiques combinatoires et/ou séquentielles habituellement utilisées dans les circuits intégrés. De préférence, la logique dynamique mise en oeuvre par les cellules selon le deuxième mode de réalisation est une logique adiabatique.

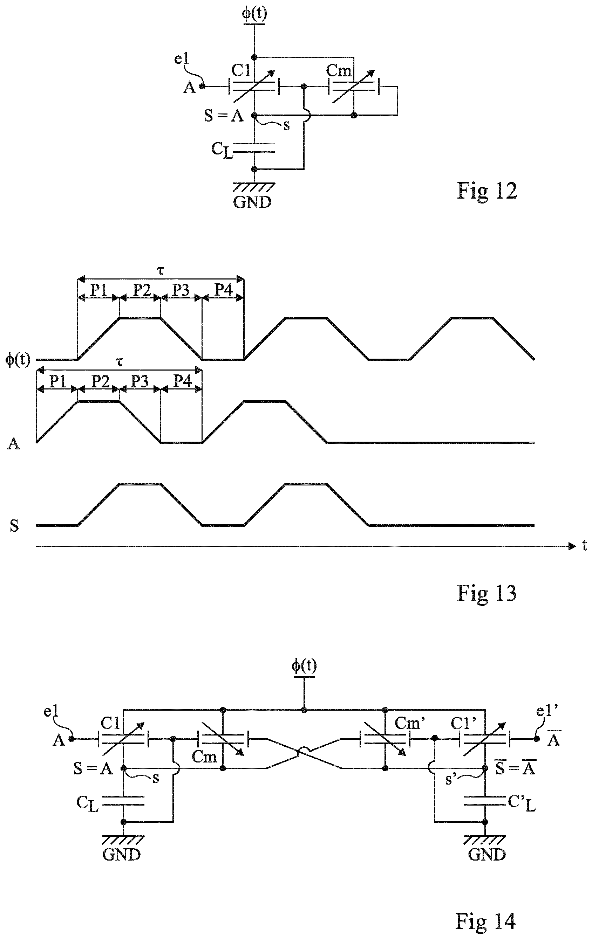

La figure 12 est un schéma électrique d'un exemple d'une cellule logique adiabatique de type buffer selon le deuxième mode de réalisation. La cellule de la figure 12 comprend les mêmes éléments que la cellule buffer de la figure 3, agencés sensiblement de la même manière, mais diffère de la cellule de la figure 3 en ce que, dans la cellule de la figure 12, la tension d'alimentation continue VDD de la cellule de la figure 3 est remplacée par une tension d'alimentation variable périodique $\Phi(t)$, fournie par une source de tension variable non représentée. En outre, la cellule de la figure 12 comprend un circuit de maintien et de remise à zéro comportant un condensateur à capacité variable Cm, par exemple identique au condensateur C1, dont les électrodes principales sont connectées respectivement au noeud d'application de la tension d'alimentation $\Phi(t)$ et au noeud de sortie s de la cellule, et dont les électrodes de commande sont connectées respectivement au noeud de sortie s de la cellule et au noeud GND.

La figure 13 est un diagramme illustrant le fonctionnement de la cellule de la figure 12. Plus particulièrement, la figure 13 illustre l'évolution, en fonction du temps, de la tension d'alimentation $\Phi(1)$, du signal logique d'entrée A, et du signal logique de sortie S de la cellule de la figure 12.

Dans l'exemple représenté, la tension d'alimentation $\Phi(t)$ est une tension trapézoïdale. Plus particulièrement, dans cet exemple, chaque période $\tau$ de la tension $\Phi(t)$ comprend quatre phases successives P1, P2, P3 et P4 sensiblement de même durée $T=T/4$. Lors de la phase P1, la tension $\Phi(t)$ croit linéairement depuis une valeur basse, par exemple de l'ordre de 0 V, jusqu'à une valeur haute VDD. Lors de la phase P2, la tension $\Phi(t)$ reste sensiblement égale à sa valeur haute VDD. Lors de la phase P3, la tension $\Phi(t)$ décroit linéairement depuis sa valeur haute VDD jusqu'à sa valeur basse. Lors de la phase P4, la tension $\Phi(t)$ reste sensiblement égale à sa valeur basse.

Les signaux logiques A et S sont synchronisés sur la tension d'alimentation $\Phi(t)$ qui sert aussi de signal d'horloge. Les tensions définissant les signaux logiques A et S présentent une variation périodique de forme sensiblement identique à celle de la tension d'alimentation variable $\Phi(t)$. Le signal logique A ou S est à l'état haut lorsque l'amplitude de la tension variable périodique le définissant est à un niveau haut, par exemple proche de l'amplitude VDD de la tension d'alimentation $\Phi(t)$. Le signal logiques A ou S est à l'état bas lorsque l'amplitude de la tension variable périodique le définissant est à un niveau bas, par exemple proche de 0 V. Le signal A présente une avance de phase de l'ordre de $\tau/4$ sur la tension d'alimentation $\Phi(t)$. Le signal S est quant à lui en phase avec la tension d'alimentation $\Phi(t)$.

Dans l'exemple représenté, le signal d'entrée A est à l'état haut pendant deux périodes $\tau$ successives, puis passe à l'état bas.

Lorsque le signal A est à l'état haut, la capacité du condensateur C1 passe progressivement de sa valeur basse $C1_{low}$ à sa valeur haute $C1_{high}$ pendant la phase P1 de croissance linéaire du signal A. A la fin de la phase P1, lorsque la capacité du condensateur C1 est à sa valeur haute $C1_{high}$, la tension de sortie de la cellule est sensiblement égale à la tension d'alimentation $\Phi(1)$, qui, à ce stade, est approximativement nulle (fin de la phase P4 de la tension $\Phi(t)$). Pendant la phase P2 du signal A, la capacité du condensateur C1 reste à sa valeur haute $C1_{high}$, et la tension de sortie de la cellule suit sensiblement la croissance linéaire de la tension d'alimentation $\Phi(t)$ (phase P1 de la tension $\Phi(t)$). Pendant la phase P3 de décroissance linéaire du signal A, la capacité du condensateur C1 décroit progressivement depuis sa valeur haute $C1_{high}$ jusqu'à sa valeur basse $C1_{low}$. Le condensateur Cm du circuit de maintien étant commandé par le signal de sortie S de la cellule, la capacité du condensateur Cm est à sa valeur haute $Cm_{high}$ au début de la phase P3 du signal A. La mise en parallèle des condensateurs C1 et Cm permet de maintenir la capacité équivalente entre le noeud d'alimentation $\Phi(t)$ et le noeud de sortie s de la cellule à une valeur relativement haute pendant la phase P3 du signal A. Ainsi, le signal S reste sensiblement égal à la valeur de la tension d'alimentation $\Phi(t)$ (c'est-à-dire à la valeur VDD) pendant toute la durée de la phase P3 du signal A (correspondant à la phase P2 de la tension d'alimentation $\Phi(1)$). Pendant la phase P4 du signal A, correspondant à la phase P3 de la tension d'alimentation $\Phi(t)$, la tension $\Phi(t)$ décroit linéairement depuis sa valeur haute VDD jusqu'à une valeur sensiblement nulle (par décharge à travers le condensateur Cm qui reste à sa valeur haute au début de la décharge, puis prend sa valeur basse). Il en résulte que la tension de sortie de la cellule décroit progressivement jusqu'à une valeur sensiblement nulle. Dans le même temps, la capacité du condensateur Cm décroit progressivement jusqu'à sa valeur basse $Cm_{low}$.

Lorsque le signal A est à l'état bas, les capacités des condensateurs C1 et Cm restent en permanence à leurs valeurs basses, de sorte que la tension de sortie S de la cellule reste toujours sensiblement nulle.

En pratique, le dispositif de maintien et de remise à zéro peut parfois être omis. En particulier, dans certains cas, un phénomène physique peut avoir le même effet de maintien et de remise à zéro. Par exemple, dans des dispositifs électromécaniques à commande électrostatique, la force électrique peut être supérieure à la force de rappel et maintenir le dispositif dans sa position même lorsque la tension de commande est revenue à une valeur nulle. Les forces d'adhésion peuvent avoir le même effet.

En pratique, la tension d'alimentation trapézoïdale $\Phi(t)$ peut être approximée par une tension sinusoïdale de période $\tau$.

Plus généralement, toutes les cellules logiques de base et les circuits logiques décrits en relation avec les figures 2 à 11 peuvent être adaptés pour présenter un fonctionnement adiabatique du type décrit en relation avec la figure 12. Pour cela, on peut notamment prévoir de remplacer la tension d'alimentation continue VDD des cellules décrites en relation avec les figures 2 à 11 par la tension d'alimentation variable périodique $\Phi(t)$ de la cellule de la figure 12, et d'ajouter éventuellement aux cellules décrites en relation avec les figures 2 à 11 un circuit de maintien du type décrit en relation avec la figure 12. A titre de variante, et comme décrit précédemment, la fonction de maintien peut être assurée par un processus physique dans le condensateur de la cellule logique lui-même. Par exemple, dans le cas d'un condensateur à capacité variable de type système électromécanique (MEMS), la force attractive électrostatique due à la tension résiduelle entre les électrodes de sortie peut suffire à réaliser la fonction de maintien.

Par ailleurs, une logique dynamique non adiabatique peut aussi être mise en oeuvre à partir de condensateurs à capacités variables, en remplaçant la tension d'alimentation variable $\Phi(t)$ des cellules par une tension continue, et en introduisant un signal d'horloge supplémentaire (non représenté) pour la synchronisation des cellules.

Par rapport aux circuits logiques adiabatiques connus, et en particulier ceux à base d'interrupteurs micro ou nanoélectromécaniques décrits dans les demandes de brevet FR2978311 et FR3009722 susmentionnées et dans l'article de S. Houri et al. susmentionné, dont les contenus sont considérés comme faisant partie intégrante de la présente description, la logique adiabatique à base de condensateurs à capacité variable a pour avantage que la consommation dynamique non adiabatique résiduelle liée aux effets de seuil est entièrement supprimée.

La figure 14 est un schéma électrique d'un autre exemple d'une cellule logique selon le deuxième mode de réalisation.

La cellule de la figure 14 comprend sensiblement les mêmes éléments que la cellule de la figure 12, à ceci près que, dans la cellule de la figure 14, le condensateur Cm est un condensateur à variation de capacité opposée à celle du condensateur C1. Plus particulièrement, dans l'exemple représenté, le condensateur C1 est à variation positive de capacité et le condensateur Cm est à variation négative de capacité. De plus, dans la cellule de la figure 14, l'électrode de commande du condensateur Cm opposée au noeud GND n'est pas connectée au noeud de sortie s de la cellule. La cellule de la figure 14 comprend en outre un circuit logique complémentaire comportant un condensateur à capacité variable C1' identique ou similaire au condensateur C1, et un condensateur à capacité variable Cm' identique ou similaire au condensateur Cm. Les condensateurs C1' et Cm' sont reliés en parallèle, par leurs électrodes principales, entre le noeud d'application de la tension d'alimentation $\Phi$ de la cellule et un noeud de sortie complémentaire s' de la cellule. Le noeud de sortie s' présente une capacité de sortie $C_L'$. Les électrodes de commande du condensateur C1' sont reliées respectivement à un noeud e1' d'application d'un signal logique $\overline{A}$ complémentaire du signal A appliqué sur le noeud e1, et au noeud GND. Le noeud de sortie s' fournit un signal de sortie $\overline{S} = \overline{A}$ complémentaire du signal S fourni par le noeud de sortie s. L'électrode de commande du condensateur Cm opposée au noeud GND est connectée au noeud s', et les électrodes de commande du condensateur Cm' sont connectées respectivement au noeud s et au noeud GND.

Pendant les phases de montée et de descente du signal d'alimentation $\Phi(1)$, la capacité du condensateur Cm est maintenue à sa valeur haute puisqu'elle est commandée par la sortie complémentaire s' qui est à l'état bas. Dans ce cas, le signal d'alimentation est transmis sur la sortie s par le condensateur Cm. Un fonctionnement inverse est obtenu pour le circuit complémentaire.

La figure 15 est un schéma de principe illustrant, sous forme de blocs, différents éléments que peut comprendre une cellule logique à capacité variable selon le premier ou deuxième mode de réalisation.

La cellule de la figure 15 comprend un circuit principal PR (représenté en partie gauche de la figure), et peut comprendre un circuit complémentaire CP (représenté en partie droite de la figure). Le circuit complémentaire CP permet de réaliser la fonction complémentaire de celle réalisée par le circuit principal PR. Ceci permet de mettre en oeuvre un fonctionnement différentiel, et permet en outre de pouvoir réaliser des circuits logiques en utilisant uniquement des condensateurs à variation de capacité positive, ou uniquement des condensateurs à variation de capacité négative. Seul le circuit principal PR sera détaillé ci-après, le circuit CP étant le complément du circuit PR.

Le circuit PR comprend un bloc F comprenant un ou plusieurs condensateurs à capacité variable du type décrit ci-dessus, adapté à mettre en oeuvre une fonction logique F à k entrées ei (où k est un entier supérieur ou égal à 1 et i est un entier allant de 1 à k) et une sortie s fournissant un signal logique S. Le bloc F est connecté à un noeud $V_{ALIM}$ d'application d'une tension d'alimentation continue (dans le cas d'une cellule logique statique ou d'une cellule logique dynamique non adiabatique) ou variable (dans le cas d'une cellule logique adiabatique) fournie par une source de tension non représentée.

Dans le cas d'une cellule logique adiabatique, la cellule peut comprendre un premier circuit de maintien HOLD connecté entre le noeud $V_{ALIM}$ et le noeud s, par exemple un circuit du type décrit en relation avec la figure 12.

La cellule peut en outre comprendre un bloc $\overline{F}$ à k entrées ei', adapté à mettre en oeuvre la fonction logique $\overline{F}$ complémentaire de la fonction F. La sortie du bloc $\overline{F}$ est connectée au noeud s. Les entrées ei' sont destinées à recevoir les signaux complémentaires des signaux appliqués sur les entrées ei du bloc F, de sorte que les signaux de sortie des blocs F et $\overline{F}$ sont identiques.

La cellule peut de plus comprendre un bloc d'initialisation INIT, connecté d'une part au noeud de sortie s et d'autre part à un noeud REF d'application d'un potentiel de référence, par exemple la masse. Le bloc INIT peut être un circuit d'initialisation du type décrit en relation avec la figure 4, permettant de réinitialiser le potentiel du noeud de sortie s à une valeur de référence. On notera que dans le cas d'une logique dynamique, adiabatique ou non adiabatique, ou dans le cas d'une logique statique, la réinitialisation du noeud s peut par exemple être mise en oeuvre à chaque cycle d'horloge.

Les figures 16A et 16B sont des vues en coupe d'un exemple de réalisation d'un condensateur à capacité variable micro ou nanoélectromécanique susceptible d'être utilisé dans une cellule logique capacitive selon le premier ou deuxième mode de réalisation.

Le condensateur des figures 16A et 16B est un condensateur à variation positive de capacité. Ce condensateur comprend une partie fixe et une partie mobile. La partie fixe comprend une première électrode principale 101 du condensateur, et une couche diélectrique 103 revêtant une face (la face supérieure dans l'orientation de la figure) de l'électrode 101. L'électrode 101 est destinée à être connectée à un dispositif extérieur, par exemple au noeud de sortie s dans une cellule logique capacitive du type décrit en relation avec la figure 3.

L'électrode 101 est montée solidaire d'une pièce métallique 105, par exemple un bras ou une plaque métallique, par l'intermédiaire d'une pièce isolante 107, de façon que l'électrode 101 soit isolée électriquement de la pièce 105. La pièce 105 forme une première électrode de commande du condensateur, destinée à être connectée à un noeud de référence d'un circuit, par exemple au noeud GND dans une cellule logique capacitive du type décrit en relation avec la figure 3. La partie mobile comprend la deuxième électrode principale 109 du condensateur. L'électrode mobile 109 est située en regard de la couche diélectrique 103 revêtant l'électrode 101. L'électrode 109 est destinée à être connectée à un dispositif extérieur, par exemple au noeud d'alimentation VDD dans une cellule logique capacitive du type décrit en relation avec la figure 3. L'électrode 109 est montée solidaire d'une pièce métallique 111, par exemple un bras ou une plaque métallique, par l'intermédiaire d'une pièce isolante 113, de façon que l'électrode 109 soit isolée électriquement de la pièce 111. La pièce métallique 111 est située en regard de la pièce métallique 105. La pièce 111 forme la deuxième électrode de commande du condensateur, destinée à être connectée à un noeud d'application d'un signal de commande de la capacité du condensateur, par exemple le noeud d'entrée e1 dans une cellule logique capacitive du type décrit en relation avec la figure 3.

L'application d'une tension de commande positive de niveau haut, par exemple proche de VDD, sur la pièce métallique 111 (référencée par rapport à la pièce métallique 105), conduit à rapprocher la pièce 111 de la pièce 105, et donc l'électrode 109 de l'électrode 101 (par exemple jusqu'à mettre l'électrode 109 en contact avec la couche 103). Il en résulte une augmentation de la capacité formée entre les électrodes 101 et 109. Cette configuration est illustrée par la figure 16B.

L'application d'une tension de commande de niveau bas, par exemple une tension négative ou une tension proche de 0 V, sur la pièce métallique 111, conduit à éloigner la pièce 111 de la pièce 105, et donc l'électrode 109 de l'électrode 101. Il en résulte une diminution de la capacité formée entre les électrodes 101 et 109. Cette configuration est illustrée par la figure 16A.

En pratique, le condensateur peut en outre comporter un ressort (non représenté) de rappel de la partie mobile dans l'une ou l'autre des deux positions (proche de la partie fixe ou éloignée de la partie fixe) susmentionnées. A titre de variante, le rappel de la partie mobile vers sa position initiale peut être assuré par la raideur naturelle de l'ensemble formé par les éléments 111, 113 et 109 de la partie mobile.

Les figures 17A et 17B sont des vues en coupe d'un autre exemple de réalisation d'un condensateur à capacité variable micro ou nanoélectromécanique susceptible d'être utilisé dans une cellule logique capacitive selon le premier ou deuxième mode de réalisation.

Le condensateur des figures 17A et 17B est un condensateur à variation négative de capacité. Ce condensateur comprend une partie fixe et une partie mobile.

La partie fixe comprend une première électrode principale 201 du condensateur, et une couche diélectrique 203 revêtant une face (la face inférieure dans l'orientation de la figure) de l'électrode 201. L'électrode 201 est destinée à être connectée à un dispositif extérieur, par exemple au noeud d'alimentation VDD dans une cellule logique capacitive du type décrit en relation avec la figure 2. La partie mobile comprend la deuxième électrode principale 205 du condensateur. L'électrode mobile 205 est située en regard de la couche diélectrique 203 revêtant l'électrode 201. L'électrode 205 est destinée à être connectée à un dispositif extérieur, par exemple au noeud de sortie s dans une cellule logique capacitive du type décrit en relation avec la figure 2. L'électrode 205 est montée solidaire d'une pièce métallique 207, par exemple un bras ou une plaque métallique, par l'intermédiaire d'une pièce isolante 209, de façon que l'électrode 205 soit isolée électriquement de la pièce 207. La pièce 207 forme une première électrode de commande du condensateur, destinée à être connectée à un noeud d'application d'un signal de commande de la capacité du condensateur, par exemple le noeud d'entrée e1 dans une cellule logique capacitive du type décrit en relation avec la figure 2. La partie fixe du condensateur comprend en outre, du côté de l'électrode mobile 205 opposé à l'électrode 201, une électrode secondaire 211 revêtue d'une couche diélectrique 213 du côté de sa face tournée vers l'électrode 205. L'électrode secondaire 211 est connectée électriquement à une pièce métallique 215, par exemple un bras ou une plaque métallique, située en regard de la pièce métallique 207. La pièce métallique 215 forme une deuxième électrode de commande du condensateur, destinée à être connectée à un noeud de référence d'un circuit, par exemple au noeud GND dans une cellule logique capacitive du type décrit en relation avec la figure 2. L'électrode mobile 205 est adaptée à se déplacer librement entre les électrodes 201 et 211, pour s'éloigner de l'électrode 201 en se rapprochant de l'électrode 211, ou inversement.

L'application d'une tension de commande positive de niveau haut, par exemple proche de VDD, sur la pièce métallique 207 (référencée par rapport à la pièce métallique 215), conduit à rapprocher la pièce 207 de la pièce 215, et donc à éloigner l'électrode 205 de l'électrode 201 (par exemple jusqu'à mettre l'électrode 205 en contact avec la couche diélectrique 213 revêtant l'électrode 211). Il en résulte une diminution de la capacité formée entre les électrodes 205 et 201. Cette configuration est illustrée par la figure 16B.

L'application d'une tension de commande de niveau bas, par exemple une tension négative ou une tension proche de 0 V, sur la pièce métallique 207, conduit à éloigner la pièce 207 de la pièce 215, et donc à rapprocher l'électrode 205 de l'électrode 201 (par exemple jusqu'à mettre l'électrode 205 en contact avec la couche diélectrique 203 revêtant l'électrode 201). Il en résulte une augmentation de la capacité formée entre les électrodes 205 et 201. Cette configuration est illustrée par la figure 17A. Dans cet exemple, la couche diélectrique 213 permet de garantir l'isolation électrique entre l'électrode 215 et l'électrode 205. L'isolation électrique entre l'électrode 207 et l'électrode 205 est réalisée par l'élément 209.

En pratique, le condensateur peut en outre comporter un ressort (non représenté) de rappel de la partie mobile dans l'une ou l'autre des deux positions représentées en figures 17A et 17B. A titre de variante, le rappel de la partie mobile vers sa position initiale peut être assuré par la raideur naturelle de l'ensemble formé par les éléments 207, 209 et 205 de la partie mobile.

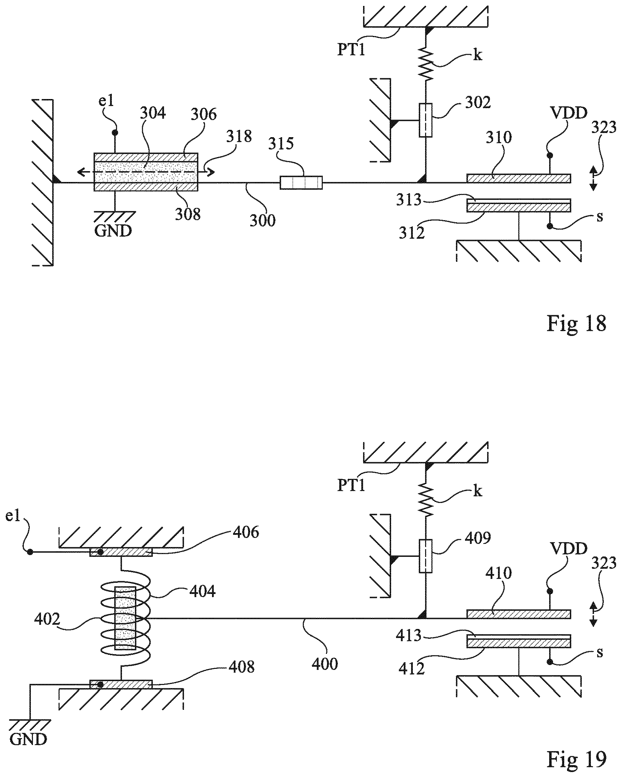

La figure 18 est une vue en coupe schématique d'un autre exemple de réalisation d'un condensateur à capacité variable susceptible d'être utilisé dans une cellule logique capacitive selon le premier ou deuxième mode de réalisation.

Le condensateur de la figure 18 comprend une poutre 300, par exemple une poutre métallique, dont une extrémité est fixe et dont l'autre extrémité est libre. Du côté de son extrémité libre, la poutre 300 est reliée à un point fixe PT1 situé en dehors de l'axe principal de la poutre, par l'intermédiaire d'un ressort de rappel k. Plus particulièrement, dans l'exemple représenté, le ressort k est un ressort de traction ou de compression dont une extrémité est reliée au point fixe PT1, et dont l'autre extrémité est reliée à la poutre 300 par l'intermédiaire d'une liaison glissière 302. Ainsi, l'extrémité libre de la poutre peut se déplacer uniquement selon une direction sensiblement parallèle à l'axe de la liaison glissière 302. Dans l'exemple représenté, le ressort k et la liaison glissière 302 sont disposés sensiblement selon un même axe orthogonal à l'axe principal de la poutre 300.

Le condensateur de la figure 18 comprend un élément piézoélectrique 304 monté solidaire de la poutre 300, de préférence du côté de l'extrémité fixe de la poutre (pour bénéficier de l'amplification, par la poutre, du mouvement généré par l'élément piézoélectrique). L'élément piézoélectrique 304 est disposé entre deux électrodes 306 et 308, sensiblement parallèles à l'axe principal de la poutre 300. Les électrodes 306 et 308 forment les électrodes de commande du condensateur, et sont destinées à être connectées à un dispositif extérieur, par exemple respectivement au noeud e1 et au noeud GND dans une cellule logique capacitive du type décrit en relation avec la figure 3.

Le condensateur de la figure 18 comprend de plus une électrode mobile 310 montée solidaire de la poutre 300 du côté de l'extrémité libre de la poutre, et une électrode fixe 312 sensiblement parallèle à l'électrode 310, disposée en regard de l'électrode mobile 310. Les électrodes 310 et 312 forment les électrodes principales du condensateur, et sont destinées à être connectées à un dispositif extérieur, par exemple respectivement au noeud VDD et au noeud s dans une cellule logique capacitive du type décrit en relation avec la figure 3. Dans cet exemple, la face de l'électrode 312 tournée vers l'électrode 310 est revêtue d'une couche diélectrique 313. De plus, dans cet exemple, la poutre 310 comprend une portion électriquement isolante 315 isolant l'électrode de commande 308 de l'électrode principale 310.

L'application d'une tension de commande entre les électrodes 306 et 308 provoque une élongation ou une rétractation de l'élément piézoélectrique 304 selon une direction parallèle à l'axe principal de la poutre, représentée par la flèche 321 de la figure 18. Ce mouvement est amplifié par la poutre 300 et par la liaison glissière 302, et converti en un déplacement de l'électrode 310 selon une direction parallèle à l'axe de la liaison glissière 302, représentée par la flèche 323 de la figure 18. Ainsi, l'électrode 310 s'éloigne ou se rapproche de l'électrode 312, d'où il résulte une diminution ou une augmentation de la capacité formée entre les électrodes 310 et 312.

La figure 19 est une vue en coupe schématique d'un autre exemple de réalisation d'un condensateur à capacité variable susceptible d'être utilisé dans une cellule logique capacitive selon le premier ou deuxième mode de réalisation.

Le condensateur de la figure 19 comprend une poutre 400, par exemple une poutre métallique, dont une extrémité est reliée à un aimant mobile 402. L'aimant 402 est entouré d'un enroulement conducteur 404 dont une première extrémité est connectée à une électrode 406 et dont la deuxième extrémité est connectée à une électrode 408. Dans l'exemple représenté, l'axe principal de l'enroulement 404 est sensiblement orthogonal à l'axe principal de la poutre 400. Les électrodes 406 et 408 forment les électrodes de commande du condensateur, et sont destinées à être connectées à un dispositif extérieur, par exemple respectivement au noeud e1 et au noeud GND dans une cellule logique capacitive du type décrit en relation avec la figure 3.

Du côté de son extrémité opposée à l'aimant 402, la poutre 400 est reliée à un point fixe PT1 situé en dehors de l'axe principal de la poutre, par l'intermédiaire d'un ressort de rappel k. Plus particulièrement, dans l'exemple représenté, le ressort k est un ressort de traction ou de compression dont une extrémité est reliée au point fixe PT1, et dont l'autre extrémité est reliée à la poutre 400 par l'intermédiaire d'une liaison glissière 409. Ainsi, l'extrémité de la poutre opposée à l'aimant peut se déplacer uniquement selon une direction sensiblement parallèle à l'axe de la liaison glissière 409. Dans l'exemple représenté, le ressort k et la liaison glissière 409 sont disposés selon un même axe sensiblement orthogonal à l'axe principal de la poutre 400 et sensiblement parallèle à l'axe principal de l'enroulement 404.

Le condensateur de la figure 19 comprend de plus une électrode mobile 410 montée solidaire de la poutre 400 du côté de l'extrémité de la poutre opposée à l'aimant 402, et une électrode fixe 412 sensiblement parallèle à l'électrode 410, disposée en regard de l'électrode mobile 410. Les électrodes 410 et 412 forment les électrodes principales du condensateur, et sont destinées à être connectées à un dispositif extérieur, par exemple respectivement au noeud VDD et au noeud s dans une cellule logique capacitive du type décrit en relation avec la figure 3. Dans cet exemple, la face de l'électrode 412 tournée vers l'électrode 410 est revêtue d'une couche diélectrique 413. Dans cet exemple, la poutre 400 n'est reliée électriquement à aucune des électrodes de commande 406 et 408, ce qui garantit l'isolation électrique entre les électrodes principales et les électrodes de commande même lorsque la poutre 400 est électriquement conductrice.

L'application d'un courant de commande dans la bobine 402, par l'intermédiaire des électrodes 406 et 408, génère un champ magnétique dans la bobine 402 et provoque un déplacement de l'aimant selon l'axe principal de la bobine. Il en résulte un déplacement de l'électrode 410 selon une direction parallèle à l'axe de la liaison glissière 402. Ainsi, l'électrode 410 s'éloigne ou se rapproche de l'électrode 412, d'où il résulte une diminution ou une augmentation de la capacité formée entre les électrodes 410 et 412.

On notera que, dans l'exemple de la figure 19, le condensateur à capacité variable est commandé en courant, et non en tension comme dans les exemples décrits précédemment. Les cellules logiques décrites en relation avec les figures 2 à 15 peuvent toutefois être adaptées au cas où le ou les condensateurs à capacité variable de la cellule sont commandés en courant.

Un avantage des modes de réalisation décrits dans la présente demande est qu'un condensateur à capacité variable présente des courants de fuite nuls ou négligeables par rapport à un transistor. La consommation statique des cellules logiques peut donc être considérablement réduite par rapport à des technologies à base de transistors.

En outre, les modes de réalisation décrits ne présentent pas les inconvénients susmentionnés des solutions à base d'interrupteurs microélectromécaniques ou nanoélectromécaniques, liés aux résistances de contact élevées de ces interrupteurs.

Des modes de réalisation particuliers ont été décrits. Diverses variantes et modifications apparaîtront à l'homme de l'art. En particulier, les modes de réalisation décrits ne se limitent pas à l'utilisation de condensateurs à capacité variable du type décrit en relation avec les figures 16A, 16B, 17A et 17B, 18 et 19. Plus généralement, tout condensateur à capacité variable comportant deux électrodes principales définissant la capacité variable, et deux électrodes de commande isolées des électrodes principales, peut être utilisé pour réaliser des cellules logiques selon le premier ou deuxième mode de réalisation. On pourra notamment utiliser des condensateurs à capacité variable basés sur des variations de la surface des électrodes pour faire varier la capacité, ou des condensateurs à capacité variable basés sur des variations de la distance inter-électrode (cas des figures 16A, 16B, 17A et 17B, 18 et 19), ou encore des condensateurs à capacité variable basés sur des variations de la constante diélectrique du matériau diélectrique situé entre les électrodes principales. A titre d'exemple, on pourra utiliser des condensateurs à capacité variable comportant des matériaux piézoélectriques ou ferromagnétiques ou à changement de phase entre les électrodes principales du condensateur.

En outre, bien que l'on ait décrit ci-dessus uniquement des exemples de réalisation basés sur des signaux logiques à deux états, les modes de réalisation décrits peuvent être adaptés à la mise en oeuvre d'une logique multi-niveau, c'est-à-dire dans laquelle les signaux de données peuvent prendre un nombre d'états discrets supérieur à 2.

Par ailleurs, dans les modes de réalisation décrits ci-dessus, on a considéré que la capacité de sortie $C_L$ des cellules logiques est formée uniquement par les capacités parasites des différents éléments connectés au noeud de sortie de la cellule. A titre de variante, les cellules logiques peuvent comporter un condensateur spécifique supplémentaire, non représenté, à capacité fixe ou à capacité variable, connecté entre le noeud de sortie s et le noeud de référence GND des cellules, en parallèle de la capacité $C_L$. La prévision d'un tel condensateur supplémentaire peut notamment permettre de minimiser l'influence de l'environnement de la cellule sur son comportement.

**Revendications**

1. Circuit logique comportant au moins une première cellule logique (F1) et une deuxième cellule logique (F2) cascadées en série, chaque cellule logique comportant au moins un premier condensateur (C1) à capacité variable ayant des première et deuxième électrodes principales séparées par une région isolante, et des première et deuxième électrodes de commande isolées électriquement des première et deuxième électrodes principales et adaptée à recevoir un signal de commande pour faire varier la capacité entre les première et deuxième électrodes principales, les première et deuxième électrodes de commande étant reliées respectivement à un noeud (e1) d'application d'un premier signal logique d'entrée (A) de la cellule et à un noeud de référence (GND) de la cellule, et les première et deuxième électrodes principales étant reliées respectivement à un noeud (VDD ; Φ(t)) d'application d'une tension d'alimentation de la cellule et à un noeud flottant (s) de fourniture d'un signal logique de sortie (S) de la cellule, dans lequel la première cellule (F1) a son noeud flottant (s) de fourniture d'un signal logique de sortie (S) relié au noeud (e1) d'application du premier signal logique d'entrée (A) de la deuxième cellule (F2).

2. Circuit logique selon la revendication 1, dans lequel au moins une des première (F1) et deuxième (F2) cellules logiques comporte en outre un deuxième condensateur (C2) à capacité variable ayant des première et deuxième électrodes principales séparées par une région isolante, et des première et deuxième électrodes de commande isolées électriquement des première et deuxième électrodes principales du deuxième condensateur et adaptées à recevoir un signal de commande pour faire varier la capacité entre les première et deuxième électrodes principales du deuxième condensateur, les première et deuxième électrodes de commande du deuxième condensateur (C2) étant reliées respectivement à un noeud (e2) d'application d'un deuxième signal logique d'entrée (B) de la cellule et au noeud de référence (GND) de la cellule, les premier (C1) et deuxième (C2) condensateurs étant connectés en série, via leurs électrodes principales, entre le noeud (VDD ; Φ(t)) d'application de la tension d'alimentation de la cellule et le noeud flottant (s) de fourniture du signal logique de sortie (S) de la cellule, la première électrode principale du premier condensateur (C1) étant connectée au noeud (VDD ; Φ(t)) d'application de la tension d'alimentation de la cellule, la deuxième électrode principale du premier condensateur (C1) étant connectée à la première électrode principale du deuxième condensateur (C2), et la deuxième électrode principale du deuxième condensateur (C2) étant connectée au noeud flottant (s) de fourniture du signal logique de sortie (S) de la cellule, de sorte que la deuxième électrode principale du premier condensateur (C1) est reliée au noeud flottant (s) de fourniture d'un signal logique de sortie (S) de la cellule par l'intermédiaire du deuxième condensateur (C2).

3. Circuit logique selon la revendication 2, dans lequel, dans ladite au moins une des première (F1) et deuxième (F2) cellules, les premier (C1) et deuxième (C2) condensateurs sont tous deux des condensateurs à variation positive de capacité ou sont tous deux des condensateurs à variation négative de capacité.

4. Circuit logique selon la revendication 1, dans lequel au moins une des première (F1) et deuxième (F2) cellules logiques comporte en outre un deuxième condensateur (C2) à capacité variable ayant des première et deuxième électrodes principales séparées par une région isolante, et des première et deuxième électrodes de commande isolées électriquement des première et deuxième électrodes principales du deuxième condensateur et adaptées à recevoir un signal de commande pour faire varier la capacité entre les première et deuxième électrodes principales du deuxième condensateur, les première et deuxième électrodes de commande du deuxième condensateur (C2) étant reliées respectivement à un noeud (e2) d'application d'un deuxième signal logique d'entrée (B) de la cellule et au noeud de référence (GND) de la cellule, les premier (C1) et deuxième (C2) condensateurs étant connectés en parallèle, via leurs électrodes principales, entre le noeud (VDD ; Φ(t)) d'application de la tension d'alimentation de la cellule et le noeud flottant (s) de fourniture du signal logique de sortie (S) de la cellule, les premières électrodes principales des premier (C1) et deuxième (C2) condensateurs étant connectées au noeud (VDD ; Φ(t)) d'application de la tension d'alimentation de la cellule, et les deuxièmes électrodes principales des premier (C1) et deuxième (C2) condensateurs étant connectées au noeud flottant (s) de fourniture du signal logique de sortie (S) de la cellule.

5. Circuit logique selon la revendication 4, dans lequel, dans ladite au moins une des première (F1) et deuxième (F2) cellules, les premier (C1) et deuxième (C2) condensateurs sont tous deux des condensateurs à variation positive de capacité ou sont tous deux des condensateurs à variation négative de capacité.

6. Circuit logique selon l'une quelconque des revendications 1 à 5, dans lequel chaque cellule (F1, F2) comporte un interrupteur de réinitialisation (SW) reliant le noeud flottant (s) de fourniture du signal logique de sortie (S) de la cellule au noeud de référence (GND) de la cellule.

7. Circuit logique selon l'une quelconque des revendications 1 à 6, dans lequel, dans chaque cellule (F1, F2), la tension d'alimentation (VDD) de la cellule est une tension continue.

8. Circuit logique selon l'une quelconque des revendications 1 à 6, dans lequel, dans chaque cellule (F1, F2), la tension d'alimentation (Φ(t)) de la cellule est une tension variable périodique.

9. Circuit logique selon la revendication 8, dans lequel chaque cellule (F1, F2) comporte en outre un circuit de maintien comportant un condensateur à capacité variable (Cm) ayant des première et deuxième électrodes principales séparées par une région isolante, et des première et deuxième électrodes de commande isolées électriquement des première et deuxième électrodes principales du condensateur à capacité variable (Cm) du circuit de maintien et adaptées à recevoir un signal de commande pour faire varier la capacité entre les première et deuxième électrodes principales du condensateur à capacité variable (Cm) du circuit de maintien, les première et deuxième électrodes de commande du condensateur à capacité variable (Cm) du circuit de maintien étant reliées respectivement au noeud flottant (s) de fourniture du signal logique de sortie (S) de la cellule et au noeud de référence (GND) de la cellule, et les première et deuxième électrodes principales du condensateur à capacité variable (Cm) du circuit de maintien étant reliées respectivement au noeud (Φ(t)) d'application de la tension d'alimentation de la cellule et au noeud flottant (s) de fourniture du signal logique de sortie (S) de la cellule.

10. Circuit logique selon la revendication 8, dans lequel les cellules (F1, F2) ne comportent pas de circuit de maintien spécifique pour maintenir ledit au moins un premier condensateur (C1) à capacité variable dans un état lorsque le signal de commande qui lui est appliqué varie, une fonction de maintien étant assurée par un phénomène physique inhérent à la cellule.

11. Circuit logique selon l'une quelconque des revendications 8 à 10, dans lequel, dans chaque cellule (F1, F2), la tension d'alimentation (Φ(t)) de la cellule est de forme trapézoïdale ou sinusoïdale.

12. Circuit logique selon l'une quelconque des revendications 1 à 11, dans lequel, dans chaque cellule (F1, F2), ledit au moins un premier condensateur à capacité variable (C1) est de type micro ou nanoélectromécanique.

13. Circuit logique selon l'une quelconque des revendications 1 à 12, dans lequel, dans chaque cellule (F1, F2), la variation de capacité dudit au moins un premier condensateur à capacité variable (C1) est obtenue en faisant varier la surface de ses électrodes principales, ou en faisant varier la distance entre ses électrodes principales, ou en faisant varier la constante diélectrique d'un matériau séparant ses électrodes principales.

**Patentansprüche**

1. Logikschaltung, aufweisend wenigstens eine erste Logikzelle (F1) und eine zweite Logikzelle (F2), die in Reihe geschaltet sind, wobei jede Logikzelle wenigstens einen ersten Kondensator (C1) mit variabler Kapazität aufweist, der erste und zweite Hauptelektroden aufweist, die durch einen Isolierbereich getrennt sind, sowie erste und zweite Steuerelektroden, die elektrisch von den ersten und zweiten Hauptelektroden isoliert sind und die geeignet sind ein Steuersignal zum Variieren der Kapazität zwischen den ersten und zweiten Hauptelektroden zu empfangen, wobei die ersten und zweiten Steuerelektroden jeweils mit einem Knoten (e1) zum Anlegen eines ersten Eingangs-Logiksignals (A) der Zelle und mit einem Referenzknoten (GND) der Zelle gekoppelt sind, und wobei die ersten und zweiten Hauptelektroden jeweils mit einem Knoten (VDD; Φ(t)) zum Anlegen einer Zellenversorgungsspannung und mit einem potentialfreien Knoten (s) zum Liefern eines Ausgangs-Logiksignals (S) der Zelle verbunden sind, wobei der potentialfreie Knoten (s) zum Liefern eines Ausgangs-Logiksignals (S) der erste Zelle (F1) mit dem Knoten (e1) zum Anlegen des ersten Eingangs-Logiksignals (A) der zweiten Zelle (F2) gekoppelt ist.

2. Die Logikschaltung nach Anspruch 1, wobei wenigstens eine der ersten (F1) und zweiten (F2) Logikzellen ferner einen zweiten Kondensator (C2) mit variabler Kapazität aufweist, der erste und zweite Hauptelektroden aufweist, die durch einen Isolierbereich getrennt sind, sowie erste und zweite Steuerelektroden, die elektrisch von den ersten und zweiten Hauptelektroden des zweiten Kondensators isoliert sind, und die geeignet sind ein Steuersignal zum Variieren der Kapazität zwischen den ersten und zweiten Hauptelektroden des zweiten Kondensators zu empfangen, wobei die ersten und zweiten Steuerelektroden des zweiten Kondensators (C2) jeweils mit einem Knoten (e2) zum Anlegen eines zweiten Eingangs-Logiksignals (B) der Zelle und mit dem Referenzknoten (GND) der Zelle gekoppelt sind, wobei die ersten (C1) und zweiten (C2) Kondensatoren über ihre Hauptelektroden in Reihe geschaltet sind, und zwar zwischen dem Knoten (VDD; $\Phi(t)$) zum Anlegen der Zellenversorgungsspannung und dem potentialfreien Knoten (s) zum Liefern des Ausgangs-Logiksignals (S) der Zelle, wobei die erste Hauptelektrode des ersten Kondensators (C1) mit dem Knoten (VDD; $\Phi(t)$) zum Anlegen der Zellenversorgungsspannung verbunden ist, wobei die zweite Hauptelektrode des ersten Kondensators (C1) mit der ersten Hauptelektrode des zweiten Kondensators (C2) verbunden ist, und wobei die zweite Hauptelektrode des zweiten Kondensators (C2) mit dem potentialfreien Knoten (s) zum Liefern des Ausgangs-Logiksignals (S) der Zelle verbunden ist, so dass die zweite Hauptelektrode des ersten Kondensators (C1) mit dem potentialfreien Knoten (s) zum Liefern des Ausgangs-Logiksignals (S) der Zelle über den zweiten Kondensator (C2) verbunden ist.

3. Die Logikschaltung nach Anspruch 2, wobei in den wenigstens einen ersten (F1) und zweiten (F2) Zellen die ersten (C1) und zweiten (C2) Kondensatoren jeweils beide Kondensatoren mit einer positiven Kapazitätsänderung oder Kondensatoren mit einer negativen Kapazitätsänderung sind.

4. Die Logikschaltung nach Anspruch 1, wobei wenigstens eine der ersten (F1) und zweiten (F2) Logikzellen ferner einen zweiten Kondensator (C2) mit variabler Kapazität aufweist, der erste und zweite Hauptelektroden aufweist, die durch einen Isolierbereich getrennt sind, sowie erste und zweite Steuerelektroden, die elektrisch von den ersten und zweiten Hauptelektroden des zweiten Kondensators isoliert sind und die geeignet sind ein Steuersignal zum Variieren der Kapazität zwischen den ersten und zweiten Hauptelektroden des zweiten Kondensators zu empfangen, wobei die ersten und zweiten Steuerelektroden des zweiten Kondensators (C2) jeweils mit einem Knoten (e2) zum Anlegen eines zweiten Eingangs-Logiksignals (B) der Zelle und mit dem Referenzknoten (GND) der Zelle gekoppelt sind, wobei die ersten (C1) und zweiten (C2) Kondensatoren über ihre Hauptelektroden parallel geschaltet sind, und zwar zwischen dem Knoten (VDD; $\Phi(t)$) zum Anlegen der Zellenversorgungsspannung und dem potentialfreien Knoten (s) zum Liefern des Ausgangs-Logiksignals (S) der Zelle, wobei die ersten Hauptelektroden der ersten (C1) und zweiten (C2) Kondensatoren mit dem Knoten (VDD; $\Phi(t)$) zum Anlegen der Zellenversorgungsspannung und die zweiten Hauptelektroden der ersten (C1) und zweiten (C2) Kondensatoren mit dem potentialfreien Knoten (s) zum Liefern des Ausgangs-Logiksignals (S) der Zelle verbunden sind.

5. Die Logikschaltung nach Anspruch 4, wobei in den wenigstens einen ersten (F1) und zweiten (F2) Zellen die ersten (C1) und zweiten (C2) Kondensatoren jeweils beide Kondensatoren mit einer positiven Kapazitätsänderung oder Kondensatoren mit einer negativen Kapazitätsänderung sind.

6. Die Logikschaltung nach einem der Ansprüche 1 bis 5, wobei jede Zelle (F1, F2) einen Reset-Schalter (SW) aufweist, der den potentialfreien Knoten (s) zum Liefern des Ausgangs-Logiksignals (S) der Zelle mit dem Referenzknoten (GND) der Zelle koppelt.

7. Die Logikschaltung nach einem der Ansprüche 1 bis 6, wobei in jeder Zelle (F1, F2) die Zellenversorgungsspannung (VDD) eine Gleichspannung ist.

8. Die Logikschaltung nach einem der Ansprüche 1 bis 6, wobei in jeder Zelle (F1, F2) die Zellenversorgungsspannung ($\Phi(t)$) eine variable, periodische Spannung ist.

9. Die Logikschaltung nach Anspruch 8, wobei jede Zelle (F1, F2) ferner eine Halteschaltung aufweist, die einen Kondensator (Cm) mit variabler Kapazität aufweist, der erste und zweite Hauptelektroden aufweist, die durch einen Isolierbereich getrennt sind, sowie erste und zweite Steuerelektroden, die von den ersten und zweiten Hauptelektroden des Kondensators (Cm) mit variabler Kapazität der Halteschaltung elektrisch isoliert sind und die geeignet sind ein Steuersignal zum Variieren der Kapazität zwischen den ersten und zweiten Hauptelektroden des Kondensators (Cm) mit variabler Kapazität der Halteschaltung zu empfangen, wobei die ersten und zweiten Steuerelektroden des Kondensators (Cm) mit variabler Kapazität der Halteschaltung jeweils mit dem potentialfreien Knoten (s) zum Liefern des Ausgangs-Logiksignals (S) der Zelle und mit dem Referenzknoten (GND) der Zelle gekoppelt sind, und wobei die ersten und zweiten Hauptelektroden des Kondensators (Cm) mit variabler Kapazität der Halteschaltung jeweils mit dem Knoten ($\Phi(t)$) zum Anlegen der Zellenversorgungsspannung und mit dem potentialfreien Knoten (s) zum Liefern des Ausgangs-Logiksignals (S) der Zelle gekoppelt sind.

10. Die Logikschaltung nach Anspruch 8, wobei die Zellen (F1, F2) keine spezifische Halteschaltung aufweisen um den wenigstens einen ersten Kondensator (C1) mit variabler Kapazität in einem Zustand zu halten, wenn sich das daran angelegte Steuersignal ändert, wobei eine Haltefunktion durch ein der Zelle innewohnendes physikalisches Phänomen gewährleistet ist.

11. Die Logikschaltung nach einem der Ansprüche 8 bis 10, wobei in jeder Zelle (F1, F2) die Versorgungsspannung ($\Phi(t)$) der Zelle eine trapezförmige oder sinusförmige Form aufweist.

12. Die Logikschaltung nach einem der Ansprüche 1 bis 11, wobei in jeder Zelle (F1, F2) der wenigstens eine erste Kondensator (C1) mit variabler Kapazität vom mikro- oder nanoelektromechanischen Typ ist.

13. Die Logikschaltung nach einem der Ansprüche 1 bis 12, wobei in jeder Zelle (F1, F2) die Kapazitätsänderung des wenigstens einen ersten Kondensators (C1) mit variabler Kapazität durch Ändern des Oberflächenbereichs seiner Hauptelektroden oder durch Ändern des Abstands zwischen seinen Hauptelektroden oder durch Ändern der Dielektrizitätskonstante eines seine Hauptelektroden trennenden Materials erreicht wird.

**Claims**

1. A logic circuit comprising at least one first logic cell (F1) and one second logic cell (F2) cascaded in series, each logic cell comprising at least one first variable-capacitance capacitor (C1) having first and second main electrodes separated by an insulating region, and first and second control electrodes electrically insulated from the first and second main electrodes and capable of receiving a control signal for varying the capacitance between the first and second main electrodes, the first and second control electrodes being respectively coupled to a node (e1) of application of a first input logic signal (A) of the cell and to a reference node (GND) of the cell, and the first and second main electrodes being respectively coupled to a node (VDD; $\Phi(t)$) of application of a cell power supply voltage and to a floating node (s) for supplying a logic output signal (S) of the cell, wherein the first cell (F1) has its floating node (s) for supplying a logic output signal (S) coupled to the node (e1) of application of the first logic input signal (A) of the second cell (F2).

2. The logic circuit of claim 1, wherein at least one of the first (F1) and second (F2) logic cells further comprises a second variable-capacitance capacitor (C2) having first and second main electrodes separated by an insulating region, and first and second control electrodes electrically insulated from the first and second main electrodes of the second capacitor and capable of receiving a control signal for varying the capacitance between the first and second main electrodes of the second capacitor, the first and second control electrodes of the second capacitor (C2) being respectively coupled to a node (e2) of application of a second input logic signal (B) of the cell and to the reference node (GND) of the cell, the first (C1) and second (C2) capacitors being connected in series, via their main electrodes, between the node (VDD; $\Phi(t)$) of application of the cell power supply voltage and the floating node (s) for supplying the logic output signal (S) of the cell, the first main electrode of the first capacitor (C1) being connected to the node (VDD; $\Phi(t)$) of application of the cell power supply voltage, the second main electrode of the first capacitor (C1) being connected to the first main electrode of the second capacitor (C2), and the second main electrode of the second capacitor (C2) being connected to the floating node (s) for supplying the logic output signal (S) of the cell, such that the second main electrode of the first capacitor (C1) is coupled to the floating node (s) for supplying the logic output signal (S) of the cell by the intermediate of the second capacitor (C2).

3. The logic circuit of claim 2, wherein, in said at least one of the first (F1) and second (F2) cells, the first (C1) and second (C2) capacitors are both capacitors having a positive capacitance variation or are both capacitors having a negative capacitance variation.

4. The logic circuit of claim 1, wherein at least one of the first (F1) and second (F2) logic cells further comprises a second variable-capacitance capacitor (C2) having first and second main electrodes separated by an insulating region, and first and second control electrodes electrically insulated from the first and second main electrodes of the second capacitor and capable of receiving a control signal for varying the capacitance between the first and second main electrodes of the second capacitor, the first and second control electrodes of the second capacitor (C2) being respectively coupled to a node (e2) of application of a second input logic signal (B) of the cell and to the reference node (GND) of the cell, the first (C1) and second (C2) capacitors being connected in parallel, via their main electrodes, between the node (VDD; Φ(t)) of application of the cell power supply voltage and the floating node (s) for supplying the logic output signal (S) of the cell, the first main electrodes of the first (C1) and second (C2) capacitors being connected to the node (VDD; Φ(t)) of application of the cell power supply voltage, and the second main electrodes of the first (C1) and second (C2) capacitors being connected to the floating node (s) for supplying the logic output signal (S) of the cell.

5. The logic circuit of claim 4, wherein, in said at least one of the first (F1) and second (F2) cells, the first (C1) and second (C2) capacitors are both capacitors having a positive capacitance variation or are both capacitors having a negative capacitance variation.

6. The logic circuit of any of claims 1 to 5, wherein each cell (F1, F2) comprises a reset switch (SW) coupling the floating node (s) for supplying the logic output signal (S) of the cell to the reference node (GND) of the cell.

7. The logic circuit of any of claims 1 to 6, wherein, in each cell (F1, F2), the cell power supply voltage (VDD) is a DC voltage.

8. The logic circuit of any of claims 1 to 6, wherein, in each cell (F1, F2), the cell power supply voltage (Φ(t)) is a variable periodic voltage.

9. The logic circuit of claim 8, wherein each cell (F1, F2) further comprises a hold circuit comprising a variable-capacitance capacitor (Cm) having first and second main electrodes separated by an insulating region, and first and second control electrodes electrically insulated from the first and second main electrodes of the variable-capacitance capacitor (Cm) of the holding circuit and adapted to receive a command signal for varying the capacitance between the first and the second main electrodes of the variable-capacitance capacitor (Cm) of the holding circuit, the first and second control electrodes of the variable-capacitance capacitor (Cm) of the hold circuit being respectively coupled to the floating node (s) of application of the logic output signal (S) of the cell and to the reference node (GND) of the cell, and the first and second main electrodes of the variable-capacitance capacitor (Cm) of the hold circuit being respectively coupled to the node (Φ(t)) of application of the cell power supply voltage and to the floating node (s) for supplying logic output signal (S) of the cell.

10. The logic circuit of claim 8, wherein the cells (F1, F2) comprise no specific hold circuit for holding said at least one first variable-capacitance capacitor (C1) in a state when the control signal which is applied thereto varies, a hold function being ensured by a physical phenomenon inherent to the cell.

11. The logic circuit of any of claims 8 to 10, wherein, in each cell (F1, F2), the power supply voltage (Φ(t)) of the cell has a trapezoidal or sinusoidal shape.

12. The logic circuit of any of claims 1 to 11, wherein, in each cell (F1, F2), said at least one first variable-capacitance capacitor (C1) is of micro- or nanoelectromechanical type.

13. The logic circuit of any of claims 1 to 12, wherein, in each cell (F1, F2), the capacitance variation of said at least one first variable-capacitance capacitor (C1) is obtained by varying the surface area of its main electrodes, or by varying the distance between its main electrodes, or by varying the dielectric constant of a material separating its main electrodes.

VDD

e1

A ● ── ──●── ──● S = $\overline{A}$

T2

s

T1

$C_L$

GND    GND    **Fig 1**

e1    VDD

A ●    C1

s

S = $\overline{A}$

$C_L$

GND    **Fig 2**

e1    VDD

A ●    C1

s

S = A

$C_L$

GND    **Fig 3**

e1    VDD

A ●    C1

s

S = $\overline{A}$

R

RST ●    SW    $C_L$

GND  GND    **Fig 4**

Fig 5

Fig 6

Fig 7

Fig 8

Fig 9

Fig 10

Fig 11

Fig 12

Fig 13

Fig 14

Fig 15

Fig 16A

Fig 16B

Fig 17A

Fig 17B

Fig 18

Fig 19

## RÉFÉRENCES CITÉES DANS LA DESCRIPTION

**Documents brevets cités dans la description**

- FR 2978311
- FR 3009722
- EP 0986077 A

**Littérature non-brevet citée dans la description**

- **W C ATHAS.** Low power Digital systems based on adiabatic switching principles. *IEEE transactions on VLSI systems,* Décembre 1994, vol. 2 (4
- **S. HOURI et al.** Limits of CMOS Technology and Interest of NEMS Relays for Adiabatic Logic Applications. *IEEE TRANSACTIONS ON CIRCUITS AND SYSTEMS I,* Septembre 2014